(19) Europäisches Patentamt
European Patent Office
Office européen des brevets

(11) **EP 3 020 629 A1**

(12) **EUROPÄISCHE PATENTANMELDUNG**

(43) Veröffentlichungstag:
**18.05.2016 Patentblatt 2016/20**

(21) Anmeldenummer: **14193280.6**

(22) Anmeldetag: **14.11.2014**

(51) Int Cl.:
*B64C 3/48* $^{(2006.01)}$  *F16H 57/00* $^{(2012.01)}$
*F16H 21/10* $^{(2006.01)}$  *G06F 17/50* $^{(2006.01)}$
*B64C 3/44* $^{(2006.01)}$

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Airbus Defence and Space GmbH**
**85521 Ottobrunn (DE)**

(72) Erfinder: **Storm, Stefan**
**85716 Unterschleißheim (DE)**

(74) Vertreter: **Kastel, Stefan et al**
**Kastel Patentanwälte**
**St.-Cajetan-Straße 41**
**81699 München (DE)**

(54) **Konstruktionsverfahren für eine Hebelkinematik, Verwendungen desselben und entsprechendes Computerprogrammprodukt**

(57)    Zur Vereinfachung einer Konstruktion von Hebelkinematiken unter schwierigen Einbau- und Randbedingungen schafft die Erfindung ein Konstruktionsverfahren zum Konstruieren einer Hebelkinematik (34) mit einem Haupthebel (36) und wenigstens einer Verbindungsstrebe (38), wobei der Haupthebel (36) um eine Haupthebelachse um einen vorgegebenen Winkel (α) drehbar ist und wobei die Verbindungsstrebe (38) einen Kraftangriffspunkt (26) mit einem Gelenkpunkt (42) an dem Haupthebel (36) verbindet, und wobei bei Beginn des Drehwinkels (α) eine erste Lage (26S) des Kraftangriffspunkts (26) vorgegeben ist und am Ende des Drehwinkels (α) eine zweite Lage (26E) des Kraftangriffspunkts (26) vorgegeben ist, gekennzeichnet durch die folgenden Schritte:
a) Darstellen einer Linie (48, 48S, 48E) der möglichen Gelenkpunkte (42) für den gegebenen Drehwinkel (α), die Hauptachse (44) und die erste und zweite Lage des Kraftangriffspunkts (26), und
b) Auswahl des Gelenkpunkts (42) auf der Linie (48, 48S, 48E).

Weiter werden Verwendungen des Konstruktionsverfahrens beschrieben.

Fig. 3

**Beschreibung**

Die Erfindung betrifft ein Konstruktionsverfahren zum Konstruieren einer Hebelkinematik mit den Merkmalen des Oberbegriffs des Anspruchs 1 sowie Verwendungen desselben.

Eine entsprechend konstruierte Hebelkinematik ist beispielsweise in der EP 0 130 983 B1 oder der US 4 427 168 offenbart.

Zur Strukturverformung flexibler Hautstrukturen, wie z.B. für spaltfreie Hochauftriebskonfigurationen an Flügelvorderkanten von Flugzeugen oder dergleichen Luftfahrzeugen, müssen an verteilten Kraftangriffspunkten genau festgelegte Bahnkurven abgefahren werden. Um die Komplexität des Gesamtsystems zu reduzieren, sollte die Aktuatorik effektiv gekoppelt sein. Es ist erwünscht, dass mit nur einem zentralen Antrieb, wie beispielsweise einem Rotationsantrieb, einzelne Teil-Kinematiksysteme (pro Kinematiksystem ist jeweils ein Kraftangriffspunkt enthalten) betrieben werden. Bei der Konstruktion derartiger Strukturaufbauten und deren Antrieben besteht das Problem, geeignete Kinematik-Knotenpunkte für eine Drehachse des Haupthebels und für Verbindungspunkte der Verbindungsstreben zu definieren, die in einem eingeschränkten Bauraum den Steifigkeitsspezifikationen und Masse-Spezifikationen entsprechen.

Ein möglicher Ansatz zur Konstruktion könnte sein, das Kinematik-Problem numerisch aufzustellen und mittels eines Optimierungsverfahrens zu lösen. Da aber ein Einfluss auf die Lösungsfindung, z.B. über zusätzliche Randbedingungen, nur beschränkt möglich ist und ein ungeeignetes Ergebnis keinen Aufschluss auf die Ursache - wie z.B. falsche oder unlösbare Randbedingungen - zulässt, ist der numerische Ansatz für anspruchsvolle Problemstellungen nicht oder bestenfalls zur Feinoptimierung einsetzbar.

Die Erfindung hat sich zur Aufgabe gestellt, ein Konstruktionsverfahren zur Konstruktion einer Hebelkinematik bereitzustellen, mit der auch komplizierte Hebelmechaniken auch unter schwierigen Randbedingungen in relativ einfacher Weise konstruiert werden können.

Zum Lösen dieser Aufgabe sind das Konstruktionsverfahren gemäß Anspruch 1, eine Verwendung des Hebelmechanikkonstruktionsverfahrens gemäß Anspruch 6 sowie Verwendungen des Konstruktionsverfahrens gemäß Anspruch 7 vorgesehen. Ein Herstellverfahren unter Verwendung eines derartigen Konstruktionsverfahrens sowie ein Computerprogramm-Produkt mit Computerprogrammcodes, mit denen sich das Konstruktionsverfahren auf einem Computer ausführen lässt, sind Gegenstand der weiteren Ansprüche.

Vorteilhafte Ausgestaltungen der Erfindung sind Gegenstand der Unteransprüche.

Die Erfindung schafft ein Konstruktionsverfahren zum Konstruieren einer Hebelkinematik mit einem Haupthebel und wenigstens einer Verbindungsstrebe, wobei der Haupthebel um eine Haupthebelachse um einen vorgegebenen Winkel drehbar ist und wobei die Verbindungsstrebe einen Kraftangriffspunkt mit einem Gelenkknoten an dem Haupthebel verbindet, und wobei bei Beginn des Drehwinkels eine erste Lage des Kraftangriffspunkts vorgegeben ist und am Ende des Drehwinkels eine zweite Lage des Kraftangriffspunkts vorgegeben ist, gekennzeichnet durch den Schritt:

a) Darstellen einer Linie der möglichen Gelenkpunkte für den gegebenen Drehwinkel, die Hauptachse und die erste und zweite Lage des Kraftangriffspunkts als Auswahlhilfe zum Auswählen des Gelenkpunkts.

Die Linie - im Folgenden auch Isogone genannt - stellt die Orte möglicher Gelenkpunkte dar und kann somit für den Konstrukteur dazu dienen, sofort mögliche Lösungen anhand einer Darstellung zu erkennen. Ideale Gelenkpunkte sind auf der Linie angegeben. Eventuell können für nicht ideale aber immer noch funktionierende Lösungen auch Gelenkpunkte im Nahbereich um die Linie ausgewählt werden.

Für die ideale Lösung umfasst das Konstruktionsverfahren vorzugsweise den weiteren Schritt:

b) Auswahl des Gelenkpunkts auf der Linie.

Ein bevorzugtes Konstruktionsverfahren ist gekennzeichnet durch geometrisches Darstellen des Haupthebels zu Beginn und Ende des Drehwinkels und des ersten und des zweiten Angriffspunkts.

Es ist bevorzugt, dass Schritt a) enthält:

Darstellen der Linie für den Beginn des Drehwinkels und Darstellen der Linie für das Ende des Drehwinkels.

Es ist bevorzugt, dass Schritt a) enthält:

geometrisches Konstruieren der Linie in Form einer Geraden aufgrund von

- Parallelitätsbedingungen,
- Symmetriebedingungen,
- Kollinearitätsbedingungen und/oder

- Rechtwinkligkeitsbedingungen.

Es ist bevorzugt, dass Schritt b) enthält:

Auswahl des Gelenkknotenpunktes aufgrund von Randbedingungen und/oder Platzverhältnissen für die Hebelkinematik.

Es ist bevorzugt, dass die Auswahl des Gelenkknotenpunkts anhand von Randbedingungen an beiden Endpunkten des Drehwinkels erfolgt.

Um die wirkenden Kräfte in der Hebelkinematik und der Stützstruktur gering zu halten und somit ein geringes Gewicht der gesamten Hebelkinematik zu erzielen, werden vorzugsweise große Drehwinkel des Haupthebels gewählt - dadurch lässt sich eine hohe Untersetzung erreichen -, sofern der verfügbare Bauraum dies zulässt.

Die Lage der Drehachse wird vorzugsweise in Abhängigkeit von der Wahl des Antriebs und/oder der Stützstruktur ausgewählt. Z.B. ist der Bereich die Drehachse des Haupthebels bei direkter Kopplung mit einem Rotationsantrieb durch die Abmessungen des Antriebs vorgegeben, sofern dieser innerhalb des verfügbaren Bauraums liegen muss.

Die Wirkrichtung der Kraft auf die Verbindungsstrebe wird vorzugsweise abhängig von der Anordnung der Hebelkinematik zur Hautstruktur und der Kraftwirkung auf die Hautstruktur ausgewählt.

Bei einer bevorzugten Vorgehensweise wird ein Vorzeichenwechsel des Kraftvektors entlang der Verbindungsstrebe vermieden, damit ein eventuelles Lagerspiel nicht zu unerwünschten Stoßbelastungen führt. Dies kann durch die Auswahl des Gelenkpunktes für die Verbindungsstrebe beeinflusst werden.

Wird eine Hebelkinematik zum Antreiben einer Umformung einer flexiblen Hautstruktur konstruiert, erfolgt eine Auswahl vorzugsweise im Hinblick auf eine gleichmäßige Bewegung aller Kraftpunkte. Für den Antrieb flexibler Hautstrukturen ist die gleichförmige Bewegung aller Kraftangriffspunkte vorrangiges Kriterium zur Auswahl von Knoten- oder Gelenkpunkten. Sollte ein einzelner Kraftangriffspunkt vorauseilen oder nachlaufen, würde dies bei einer flexiblen Hautstruktur sofort zum Ausbeulen bzw. zur Strömungsveränderung führen.

Die Vorgehensweise zur Auslegung einer Hebelkinematikeinheit erfolgt vorzugsweise in der Reihenfolge: 1) Wahl des Antriebs, 2) Wahl der Drehachse, 3) Wahl des Drehwinkels, 4) Wahl des Gelenkpunktes auf der Start- bzw. Ziel-Isogonen. Sofern kein geeigneter Gelenkpunkt gefunden werden kann, sollte zunächst geprüft werden, ob ein veränderter Drehwinkel zum Erfolg führt, erst anschließend sollte die Drehachse oder der Antrieb verändert werden. Gründe für nicht geeignete Gelenkpunkte sind z.B. nicht konstruierbar, da nicht mehr innerhalb des Bauraums, nicht zusammenbaubar, zu geringe Hebellängen der Verbindungsstrebe oder des Haupthebels, ungeeignete bzw. spitze Winkel (z.B. kleiner 40°) zur Hautstruktur, zu hohe Kräfte.

Gemäß einem weiteren Aspekt schafft die Erfindung ein Hebelmechanikkonstruktionsverfahren zur Konstruktion einer Hebelmechanikanordnung mit gekoppelten Hebelkinematiken, von denen jede Hebelkinematik umfasst: einen Haupthebel und wenigstens eine Verbindungsstrebe derart, dass der Haupthebel um eine Haupthebelachse um einen vorgegebenen Winkel drehbar ist und dass die Verbindungsstrebe einen Kraftangriffspunkt mit einem Gelenkpunkt an dem Haupthebel verbindet, und dass bei Beginn des Drehwinkels eine erste Lage des Kraftangriffspunkts vorgegeben ist und am Ende des Drehwinkels eine zweite Lage des Kraftangriffspunkts vorgegeben ist, umfassend:

Auswählen derjenigen der Hebelkinematiken, die die meisten Randbedingungen zu erfüllen hat, als überrangige Master-Kinematik,
Durchführen des Konstruktionsverfahrens nach einer der voranstehend erläuterten Ausgestaltungen für die Master-Kinematik und
nachfolgendes Durchführen des Konstruktionsverfahrens für eine weitere gekoppelte Hebelkinematik unter Berücksichtigung der Konstruktion der Masterkinematik als Randbedingung.

Vorzugsweise wird das Konstruktionsverfahren zur Konstruktion einer Antriebsmechanik zur Strukturverformung flexibler Hautstrukturen verwendet.

Vorzugsweise wird das Konstruktionsverfahren zur Konstruktion einer Antriebsmechanik für eine Hochauftriebsanordnung an einer Flügelvorderkante eines Luftfahrzeugs verwendet.

Vorzugsweise wird das Konstruktionsverfahren zur Konstruktion einer Ansteuerung von Steuerflächen an Flugzeugen, Hubschraubern oder sonstigen Luftfahrzeugen verwendet.

Vorzugsweise wird das Konstruktionsverfahren zur Konstruktion einer Ansteuerung von fluiddynamisch wirksamen Flächen an fluiddynamischen Körpern verwendet.

Vorzugsweise wird das Konstruktionsverfahren zur Konstruktion einer Ansteuerung von Klappen an Fahrzeugen, Luftfahrzeugen und Fluggeräten verwendet. Vorzugsweise wird das Konstruktionsverfahren zur Konstruktion von Fahrwerkkinematiken von Fahrzeugen und Luftfahrzeugen verwendet.

Vorzugsweise wird das Konstruktionsverfahren zur Konstruktion von Scharniersystemen oder Bewegungskinematiken von Türen, beispielsweise von Fahrzeugen und Luftfahrzeugen, verwendet.

Eine weitere bevorzugte Verwendung ist die Konstruktion von Antriebsmechanismen, mit denen Windradflügel in ihrer strömungswirksamen Form verändert werden können, um sich an Windverhältnisse anzupassen. Dies kann insbesondere auf gleiche Weise wie bei Flugzeugflügeln mit flexiblen Hautstrukturen erfolgen. Eine Formveränderung kann z.B. an der Vorderkante und/oder der Hinterkante des Windradflügels ermöglicht werden. Derartige Veränderungen lassen sich mit Hebelmechaniken der durch das Verfahren konstruierbaren Art von der zentralen Nabe des Windrades aus einfach ansteuern.

Gemäß einem weiteren Aspekt betrifft die Erfindung ein Herstellverfahren zum Herstellen einer Hebelkinematik, mit einem Haupthebel und wenigstens einer Verbindungsstrebe, wobei der Haupthebel um eine Haupthebelachse um einen vorgegebenen Winkel drehbar ist und wobei die Verbindungsstrebe einen Kraftangriffspunkt mit einem Gelenkpunkt an dem Haupthebel verbindet, und wobei bei Beginn des Drehwinkels eine erste Lage des Kraftangriffspunkts vorgegeben ist und am Ende des Drehwinkels eine zweite Lage des Kraftangriffspunkts vorgegeben ist, mit den Schritten: Durchführen eines Konstruktionsverfahrens nach einer der voranstehenden Ausgestaltungen und Herstellen des Haupthebels und der Verbindungsstrebe und aneinander Anlenken derselben an dem durch das Konstruktionsverfahren ermittelten Gelenkknotenpunkt.

Gemäß einem weiteren Aspekt betrifft die Erfindung ein Computerprogrammprodukt, dadurch gekennzeichnet, dass es ein Computerprogramm mit Computerprogrammcodemitteln umfasst, das dazu ausgebildet ist, einen Computer oder Prozessor zum Ausführen der Schritte eines Verfahrens nach einer der voranstehenden Ausgestaltungen zu veranlassen.

Die Erfindung schlägt zur vereinfachten Konstruktion auch komplizierter Hebelkinematiken vor, zunächst für eine gegebene Drehachse des Haupthebels und einen dazugehörigen Drehwinkel diejenigen geometrischen Kurven darzustellen, auf denen die zulässigen Kinematik-Knotenpunkte liegen. Diese Kurven werden im Folgenden auch als "Isogonen", nämlich als Linien entsprechend dem gleichen Winkel, bezeichnet. Vorzugsweise wird anschließend ein Knotenpunkt auf einer Isogone ausgewählt, der das Kinematik-Problem am Besten löst. Eventuell kommen auch Punkte nahe der Isogone in Betracht. Je weiter ein Punkt von einer Isogone entfernt ist, desto weniger eignet er sich als Lösung.

Als eine einfache Methode zur Ermittlung der Isogonen bieten sich geometrische Verfahren an, um die beim analytischen Ansatz entstehenden, nicht eindeutigen Lösungen zu vermeiden. Derartige Isogonen lassen sich nicht nur für in der Ebene liegende Kinematik-Probleme, sondern auch für beliebig im Raum liegende Bahnkurven bestimmen.

Mit der Darstellung der Kurven für die möglichen Gelenkpunkte - auch Isogonen genannt - kann graphisch - insbesondere in Konstruktionsprogrammen - das beschriebene Kinematik-Problem schrittweise gelöst werden.

Es wird bildlich sofort erkennbar, ob z.B. der für das Gesamtsystem gemeinsame Drehwinkel oder die gemeinsame Drehachse korrekt gewählt wurde und welche zusätzlichen Randbedingungen möglich sind.

Zusätzliche Randbedingungen, die möglich sind, können z.B. eine Strebenausrichtung quasi-identisch zur Kraftrichtung, eine einheitliche Strebenlänge, gemeinsame Kinematik-Knotenpunkte gekoppelter Hebelkinematiken oder dergleichen sein.

Es können Schlussfolgerungen getroffen werden, z.B. welche Randbedingungen geändert werden müssen, um das Kinematik-Problem zu lösen.

Eine besonders bevorzugte Verwendung sieht eine Konstruktion einer Lasteinleitungseinrichtung und eines Strukturbauteils derart vor, wie sie in der nicht vorveröffentlichten europäischen Patentanmeldung 13 196 990.9-1754 gezeigt und beschrieben ist. Für nähere Einzelheiten wird auf den Inhalt dieser europäischen Patentanmeldung vollumfänglich Bezug genommen; der Inhalt dieser Patentanmeldung wird hierin durch Bezugnahme inkorporiert.

Es können weiter Schlussfolgerungen getroffen werden, welche Lage die Kurve möglicher Gelenkpunkte haben muss, um gegebenen Fertigungstoleranzen oder Einbautoleranzen eine robuste Kinematik-Lösung zu gewährleisten.

Ausführungsbeispiele der Erfindung werden nachfolgend anhand der beigefügten Zeichnungen näher erläutert. Darin zeigt:

Fig. 1        einen spannweitigen Schnitt durch eine Vorderkante eines Flügels mit flexibler Hautstruktur (droop nose) mit einer zweidimensionalen Projektion des Anfangszustands und Endzustands als ein Anwendungsbeispiel für ein neues Konstruktionsverfahren zur Konstruktion von Hebelkinematiken, wobei ein Sonderfall gekoppelter Hebelkinematiken gezeigt ist, bei der mehrere der Hebelkinematiken einen gemeinsamen Gelenkpunkt haben;

Fig. 2        eine einzelne Hebelkinematik als Teilkinematik der Lasteinleitungseinrichtung von Fig. 1, welche es zu konstruieren gilt;

Fig. 3        die schematisch dargestellte Hebelkinematik von Fig. 2 mit dem Drehwinkel, der Lage des Kraftangriffspunkts zum Beginn des Drehwinkels, der Lage des Kraftangriffspunkts zum Ende des Drehwinkels und der Linie der möglichen Gelenkpunkten (Isogone genannt);

Fig. 4          die graphische Darstellung der Anwendung der geometrischen Lösung von Fig. 3 für den Fall von drei anstatt zwei Kraftangriffspunkten;

Fig. 5 und 6    unterschiedliche mögliche Hebelkinematiken, die gemäß der graphischen Lösung von Fig. 3 zur Konstruktion einer Zugstrebenlösung möglich sind;

Fig. 7          eine mögliche Hebelkinematik gemäß der Lösung von Fig. 3 mit einer Schubstrebe;

Fig. 8          eine ungünstigere Hebelkinematik;

Fig. 9 und 10   schematische Darstellungen von unterschiedlichen möglichen Kinematiken für andere Drehwinkel;

Fig. 11         eine Hebelkinematik für einen Drehwinkel größer al 180°;

Fig. 12         eine Darstellung möglicher Kinematiken durch geometrische graphische Darstellung von Isogonen für verschiedene Drehwinkel von 90°, 80°, 70°, 60°, 50°, 40° und 30°;

Fig. 13         eine graphische Darstellung zur Anwendung der geometrischen Konstruktion der Hebelkinematik bei gekoppelten Teilkinematiken am Beispiel einer Lösung für eine flexible Hautstruktur einer gepfeilten Flügelvorderkante der im Profil in Fig. 1 dargestellten Art;

Fig. 14         eine schematische Darstellung zur Erläuterung unterschiedlicher Stufen einer möglichen Ausführungsform zur Ermittlung der möglichen Linie für die Gelenkpunkte;

Fig. 16         eine schematische Darstellung für eine einfache Lösung einer Konstruktion einer Hebelkinematik für eine dreidimensionale Bewegung;

Fig. 17         eine schematische Darstellung einer Auswahl eines beliebigen Punktes auf der durch die Konstruktion von Fig. 16 erhaltenen Isogonen, um eine mögliche Kinematik bei der gegebenen Ausgangssituation zu erhalten

Fig. 18         eine schematische perspektivische Darstellung der Konstruktion vergleichbar zu derjenigen gemäß Fig. 16 in einer leicht abgeänderten Ausgangssituation;

Fig. 19         eine schematische Darstellung eines Verfahrens zur Ermittlung von Isogonen vergleichbar dem Verfahren von Fig. 14 für eine dreidimensionale Ausgangssituation, wobei die Konstruktion eines ersten Ausgangspunkt auf einer Isogonen dargestellt ist;

Fig. 20         bei der in Fig. 19 dargestellten Konstellation die Konstruktion eines zweiten Ausgangspunkt auf der Isogonen, um so die Isogone festzulegen; und

Fig. 21         ausgehend von Fig. 20 die Auswahl von Gelenkpunkten, um unterschiedliche mögliche Hebelkinematiken zu konstruieren.

Im Folgenden werden neuartige Konstruktionsverfahren zur Konstruktion von Hebelkinematiken, die insbesondere bei der Konstruktion von Hebelgetrieben für einen Antrieb von Steuerflächen von Luftfahrzeugen, aber auch für andere Teile, insbesondere von Luftfahrzeugen, einzusetzen ist.

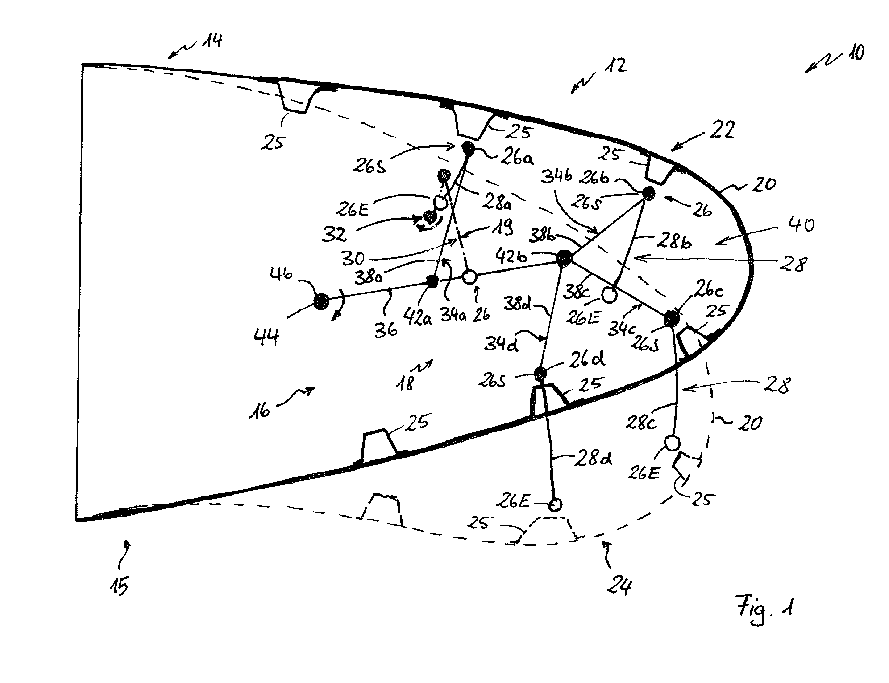

Ein Anwendungsbeispiel einer zu konstruierenden Hebelkinematik ist in Fig. 1 näher dargestellt. In Fig. 1 ist eine adaptive dünnwandige Struktur 10 mit einem verformbaren Strukturbauteil 12 an einem fluiddynamischen Strömungskörper 14 mit einer Lasteinleiteinrichtung 16 dargestellt, wobei die Lasteinleiteinrichtung 16 eine Gesamt-Hebelkinematik 18,aufweist, um die Verformung der adaptiven Struktur 10 anzutreiben. Die Gesamt-Hebelkinematik 18 ist wiederum durch einen Hebelantrieb 19 angetrieben. Die Gesamt-Hebelkinematik 18 weist mehrere gekoppelte Hebelkinematiken auf, die jeweils ein erstes Beispiel für eine zu konstruierende Hebelkinematik darstellt. Der Hebelantrieb 19 stellt ein weiteres Beispiel für eine zu konstruierende Hebelkinematik dar.

. In einem Ausführungsbeispiel ist der Strömungskörper 14 ein Flügel 15 als Teil eines Windrades einer Windkraftanlage zur Stromerzeugung. Fig. 1 zeigt dann den Schnitt durch die Vorderkante oder bevorzugt durch die Hinterkante des Flügels 15 des Windrades.

In einer anderen Ausgestaltung ist der Strömungskörper 14 beispielsweise ein Flügel 15 oder eine Flosse eines Luftfahrzeuges, wie insbesondere eines Flugzeuges. Der Flügel 15 ist dann z.B. mit einer Droop-Nose-Auftriebshilfe versehen, die durch die adaptive Struktur 10 realisiert wird

Besonders bei Laminarprofilen ist von großer Bedeutung, dass in allen Flugphasen - verschiedene Anstellwinkel und Strömungsgeschwindigkeiten - die Strömung am Flügel eine besonders lange laminare Laufstrecke besitzt. Würde man bei einem Laminarprofil auf eine adaptive Vordernase verzichten, wäre beispielsweise zur Landung des Luftfahrzeuges eine höhere Aufsetzgeschwindigkeit nötig, um eine sichere Führung des Flugzeuges zu gewährleisten.

Hierzu ist bei der Ausgestaltung von Fig. 1 eine Ausführungsform einer absenkbaren vorderen Nase dargestellt, die eine zu verformende flexible Haut 20 aufweist. Beim Absenken der Vordernase wird die Struktur 10 derart verformt, dass der Bereich der kleinsten Krümmungsradien an der Flügelvorderkante nach unten wandert, was einem Abrollen der Hautstruktur gleich kommt. Eine gute Verformbarkeit der Haut wird z.B. durch die Wahl geeigneter Materialien und einer dünnwandigen Hautstruktur erreicht. Insbesondere ist von Vorteil, wenn der Strömungskörper 14 - z.B. Flugzeugflügel - ganz fugenlos ausgebildet ist und somit die Außenhaut 20 ganz ohne Fugen zwischen einer Cruise-Stellung 22 und einer High-Lift-Stellung 24 bewegbar ist.

Derartige absenkbare Vordernasen sind beispielsweise in der europäischen Patentanmeldung mit der Anmeldenummer 13 196 990.9-1754 sowie in der DE 29 07 912 A1 gezeigt.

Die flexible Haut 20 ist hierzu mit ihren beiden sich in Spannweitenrichtung weisenden Endkanten an einer Stützstruktur befestigt und durch Versteifungselemente, wie insbesondere Stringer, mehr insbesondere Omega-Stringer 25, in Spannweitenrichtung versteift, jedoch nach oben und nach unten verformbar. Hierzu wird durch eine Lasteinleitungseinrichtung 16 eine Verformungskraft auf die flexible Haut 20 übertragen. Die Kraftangriffspunkte sind hierzu vorzugsweise an den Versteifungselementen gewählt.

Um eine derartige Vordernase an einem Flugzeug realisieren zu können, müssen demnach Lasteinleitungseinrichtungen 16 konstruiert werden, die die Last zur Verformung der Haut 20 korrekt einleiten.

Andererseits ist eine besonders schlanke Bauform des Strömungskörpers 14 erwünscht. Die Platzverhältnisse sind daher sehr beschränkt.

Es müssen Lasteinleitungseinrichtungen 16 entlang der gesamten Länge der zu verformenden adaptiven Struktur 10 wirksam sein. Eine entsprechende Konstruktion der Lasteinleitungseinrichtung 16 stellt die Konstrukteure vor einige Probleme:

Problem: "Morphing skin"

Zur Strukturverformung flexibler Hautstrukturen 10, wie z.B. für spaltfreie Hochauftriebskonfigurationen an gepfeilten Flügelvorderkanten, müssen zur Absenkung der Flügelvorderkante an verteilten Kraftangriffspunkten 26a, 26b, 26c, 26d gekrümmte Bahnkurven 28a, 28b, 28c, 28d abgefahren werden, um die gewünschte Zielkontur zu erhalten. Die beiden Profilkonturen für die Flugzustände "cruise" 22 und "high-lift" 24 sind im wesentlichen designbestimmend sowie der gleichmäßige Absenkvorgang. Die Definition der Bahnkurven 28a, 28b, 28c, 28d kann über zeitdiskretisierte Bahnpunkte oder über geometrische Näherungsfunktionen erfolgen. Die Krafteinleitung in die Hautstruktur 10 erfolgt an verschiedenen spannweitigen Positionen (Schnitten - einer davon ist in Fig. 1 dargestellt, Fig. 1 zeigt einen Schnitt rechtwinklig zur Vorderkante oder in Flug- oder Bewegungsrichtung) mit jeweils wiederum in der Schnittfläche verteilten Kraftgriffspunkten 26a, 26b, 26c, 26d. Um die Komplexität des Gesamtsystems zu reduzieren, sollte eine Aktuatorik 30 zur Durchführung der Absenkung effektiv gekoppelt werden: Es ist bevorzugt, mit möglichst nur einem zentralen (Rotations-)Antrieb 32 die einzelnen Teil-Kinematiksysteme 34a, 34b, 34c, 34d (je einen Kraftangriffspunkt 26a, 26b, 26c bzw. 26d enthaltend) gemeinsam zeitsynchron zu betreiben.

Dabei werden je Schnittfläche an einem Haupthebel 36 verschiedene Verbindungsstreben 38a, 38b, 38c, 38d angebracht, die mit den Kraftangriffspunkten 26a, 26b, 26c, 26d verbunden sind.

Zum Beispiel sind in Fig. 1 mehrere Kraftangriffspunkte 26c, 26d im Bereich der Unterseite des Strömungskörpers in Fig. 1 und mehrere Kraftangriffspunkte 26a, 26b im Bereich der Oberseite des Strömungskörpers in Fig. 1 angeordnet.

Idealerweise sollten - z.B. an benachbarten Abschnitten in Spannweitenrichtung des Flügels 15 angeordnete - benachbarte Haupthebel 36 (z.B. über eine Welle oder Gestänge) verbunden werden.

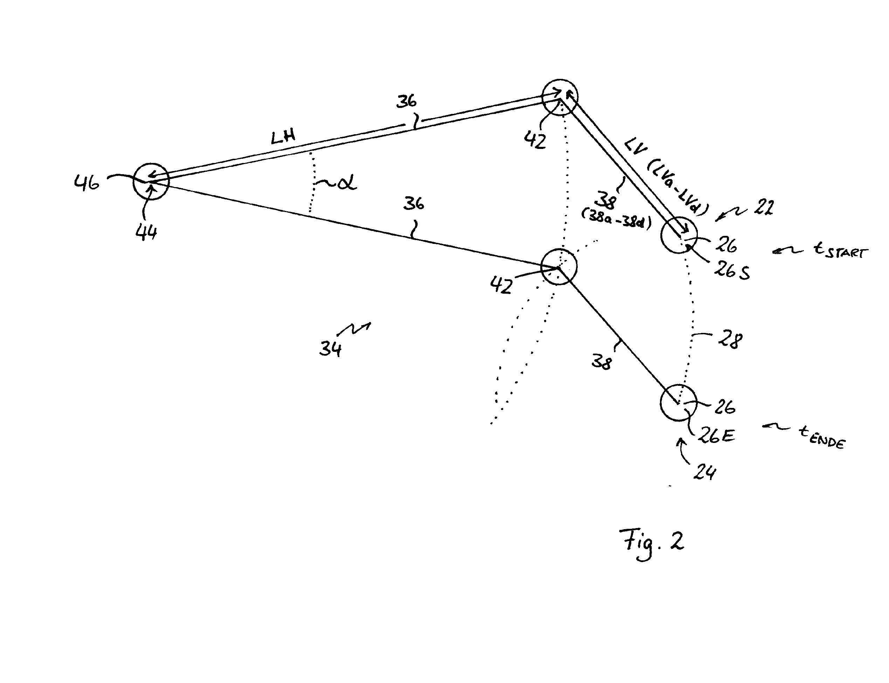

In Fig. 1 ist durch die Begrenzung der Haut 20 der Einbauraum 40 für die Gesamt-Hebelkinematik 18 angedeutet. In Fig. 2 ist eine einfache Hebelkinematik 34 als ein Beispiel für eine der Teilkinematiken 34a-34d dargestellt. Zwischen den Verbindungsstreben 38a-38d und dem Haupthebel 36 sind Gelenkpunkte 42a, 42d geschickt zu wählen. Demnach ist die Länge LH des Haupthebels, die Länge LVa-LVd der Verbindungsstreben 38a-38d, die Lage der Hauptachse 44, um die sich der Haupthebel 36 dreht und der Drehwinkel $\alpha$, den der Haupthebel 36 zur Durchführung der Bahnkurven 28a-28d drehen soll, zu wählen.

Im Folgenden werden Konstruktionsverfahren erläutert, die der Konstrukteur zum Konstruieren und Herstellen derartiger Hebelkinematiken 34 durchführen kann.

In dem dargestellten Ausführungsbeispiel greifen mehrere Verbindungsstreben, z.B. die zweite, dritte und vierte Verbindungsstrebe 38b, 38c, 38d an einem gemeinsamen zweiten Gelenkpunkt 42b an, während an einem ersten Gelenkpunkt 42a nur eine Verbindungsstrebe angreift. Zum Beispiel greift die erste Verbindungsstrebe 38a an dem ersten Gelenkpunkt 42d an. Die Gelenkpunkte 42 der jeweiligen Verbindungsstreben 38 können auch unterschiedlich gewählt werden.

Zum Konstruieren bietet es sich an, die Gesamt-Hebelkinematik 18 in mehrere Teilkinematiken 34a-34d aufzuteilen und die Parameter der Teilkinematiken 34a-34d zu bestimmen, wie dies unten noch näher dargelegt wird.

Fig. 2 zeigt eine der Teilkinematiken 34a-34d als zu konstruierende Hebelkinematik 34 mit dem Haupthebel 36 und der zugeordneten Verbindungsstrebe 38 sowie dem entsprechend zugeordneten Kraftangriffspunkt 26 und der zugeordneten Bahnkurve 28. Die Lage des Kraftangriffspunktes 26 zu Beginn der Bahnkurve bzw. Bahnkurve 38 - beispielsweise in der Cruise-Stellung 22 - wird im Folgenden mit dem Bezugszeichen 26S bezeichnet und die Lage des Kraftangriffspunktes zum Ende der Bahnkurve - beispielsweise bei der High-Lift-Stellung 24 - wird im Folgenden mit dem Bezugszeichen 26E bezeichnet.

Die Gesamt-Hebelkinematik 18 ist definiert über die Parameter:

- Drehachse oder Hauptachse 44 (Drehpunkt 46 in den Schnittdarstellungen) der Haupthebel 36 (idealerweise für alle Schnitte fluchtend),
- Gelenkknoten oder Gelenkpunkt 42 der Verbindungsstreben 38 (individuell unterschiedlich),
- Drehwinkel $\alpha$ der Haupthebel 36 (idealerweise für alle Schnitte identisch).

Eine zentrale Rolle spielt der gemeinsame Drehwinkel $\alpha$ des Rotations-Antriebs 32, der meist frei wählbar ist und im Wesentlichen die Lage der Gelenkknoten 42 der Verbindungsstreben 38 bestimmt.

Zu berücksichtigende Spezifikationen sind:

- die Masse: bedingt die Zahl der Schnitte (Kinematikstationen), die Zahl der Strebenverbindungen (Anzahl der Teil-Kinematiksysteme) und die Längen LV der Verbindungsstreben 38,
- der Einbauraum 40: bedingt die Lage der Kinematikpunkte 26, 42, 46,
- die Steifigkeit: bedingt den Bereich der Winkel zwischen Haupthebel 36 und Verbindungsstrebe 38 und zwischen Verbindungsstrebe und Hautstruktur 10.

Für die meisten Kinematiken sind Ursache und Wirkung austauschbar. Somit ist auch möglich, bei identischer Anordnung die Krafteinleitung über die Bahnkurve 28 erfolgen zu lassen (Ursache), die eine Drehbewegung eines (Haupt-)Hebels 36 bewirkt (Wirkung).

In Fig. 1 und 2 sind hierzu am Beispiel einer Hebelkinematik 34 die zu bestimmenden Parameter zur Beschreibung des 2D-Teilkinematikproblems in einem spannweitigen Schnitt zusammengestellt.

Der Drehwinkel $\alpha$ ist eine Funktion in Abhängigkeit von den Koordinaten der Drehachse 44, dem Gelenkknoten 42, der Lage 26S des Kraftangriffspunkts 26 zum Zeitpunkt tStart und der Lage 26E des Kraftangriffspunkt zum Zeitpunkt tEnde der Bahnkurve 28.

Die Bahnkurve 28 des Kraftangriffspunktes 26 kann gerade, gekrümmt oder beliebig geformt sein, sofern die Drehbewegung des Haupthebels 36 stetig in dieselbe Richtung erfolgt.

Ein klassisches Vorgehen zum Auffinden der Kinematikpunkte 26, 42, 46 wäre nun ein numerisches Verfahren, wo zur Bestimmung der Kinematikpunkte ein Gleichungssystem aufgestellt wird und die Lösung mittels einer Zielfunktion - z.B. die Abweichung von der vorgegebenen Bahnkurve - numerisch gelöst wird. Allerdings stellt sich heraus, dass der numerische Ansatz für anspruchsvolle Problemstellungen nicht oder bestenfalls zur Feinoptimierung einsetzbar ist. Grund ist, dass der Einfluss auf die Lösungsfindung nur beschränkt möglich ist, z.B. über zusätzliche Randbedingungen, und dass ein ungeeignetes Ergebnis keinerlei Aufschluss auf die Ursache für die fehlende Eignung - wie z.B. falsche oder unlösbare Randbedingungen - zulässt.

Im Gegensatz hierzu wird im Folgenden ein Lösungsansatz durch ein geometrisches Verfahren vorgeschlagen. Das Problem geometrisch zu beschreiben, ist komfortabel und anschaulich und lässt zu, gezielt Einfluss auf die Lösungsfindung zu haben.

Hierzu wird das Gesamtproblem zum Konstruieren der Gesamt-Hebelkinematik 18 in Teil-Kinematikprobleme zum Konstruieren von Hebelkinematiken 34 der TeilKinematiken 34a-34d aufgeteilt. Hierzu werden die Lage 46 der Drehachse 44 des Haupthebels 36, der Drehwinkel $\alpha$ des Haupthebels 36, ein erster Stützpunkt, z.B. ein Anfangspunkt 26S, auf der Bahnkurve 28 und ein zweiter Stützpunkt, z.B. Endpunkt 26E, auf der Bahnkurve 28 vorgegeben. Für diese Vorgaben wird eine Linie mit dem Ort aller zulässigen Gelenkpunkte 42 der Verbindungsstrebe 38 als Zwischenergebnis ermittelt und graphisch dargestellt.

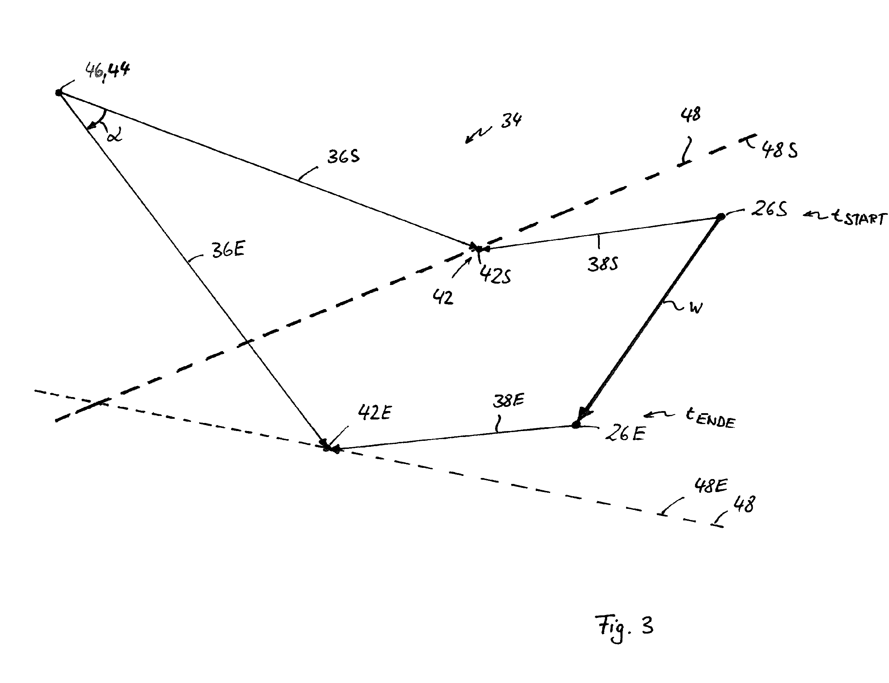

Dies ist in Fig. 3 wiedergegeben; mit der gestrichelten Linie 48 sind die Orte aller zulässigen Gelenkpunkte für den vorgegebenen Drehwinkel $\alpha$, den vorgegebenen Drehpunkt 46 des Haupthebels 36 und den vorgegebenen Startpunkt 26S und den vorgegebenen Endpunkt 26E angegeben. Weiter sind ein Beispiel eines möglichen Haupthebels 36S zum Start und die Lage des gleichen Haupthebels zum Ende 36E dargestellt. 38S und 38E zeigen ein Beispiel für die zugeordnete Verbindungsstrebe.

Da sich der Haupthebel 36 während der Bewegung um den Drehwinkel α dreht, ist zum Ende der Bahnkurve 28 auch die Linie 48 aller zulässigen Gelenkpunkte entsprechend verdreht. Die fett dargestellte Linie 48S zeigt somit die Linie 48 aller möglicher Gelenkpunkte beim Start der Bewegung (tStart) und die nicht-fett dargestellte Linie 48E zeigt demnach die Linie 48 aller zulässigen Gelenkpunkte beim Ende der Bewegung (tEnde).

Geometrisch liegen alle möglichen Gelenkknoten, die die vorgegebenen Bedingungen erfüllen, auf einer Gerade. Ist die Drehachse fest vorgegeben, so ist die Lage der Gerade ausschließlich vom Betrag des Drehwinkels α abhängig. Da eine Kurve gleichen Winkels auch als Isogone bezeichnet wird, wird im Folgenden auch dieser Begriff für die Kurve bzw. Linie 48, 48S, 48E der möglichen Gelenkknoten verwendet.

Im Prinzip stellen alle Punkte auf der Isogonen 48, 48S, 48E gültige Lösungen zum Festlegen des Gelenkpunkts 42 und damit zum Konstruieren der Hebelkinematik 34 dar, mit der durch Drehung des Haupthebels 36 um den Winkel α der Kraftangriffspunkt 26 aus seiner Startlage 26S in seine Endlage 26E verfahren werden kann. Auch gewisse Abweichungen sind insbesondere bei flexiblen Strukturen möglich. Einige mögliche Bereiche auf der Isogonen werden aber aufgrund der weiteren Randbedingungen herausfallen oder weniger günstig erscheinen. Nachdem eine oder mehrere Isogonen 48 ermittelt worden sind, kann auf einer Isogone 48 somit ein besonders geeigneter Gelenkpunkt 42 ausgewählt werden, der somit das gesamte Kinematiksystem definiert.

Mit dieser Methode ist sofort ersichtlich, ob für einen gewünschten Drehwinkel sinnvolle Gelenkpunkte im gewünschten Einbauraum möglich sind. Ist dies nicht der Fall, muss entweder der Drehwinkel geändert werden oder die Drehachse verschoben werden.

Somit hat man ein einfaches und sehr anschauliches Verfahren zur Konstruktion der Hebelkinematik 34.

Wie oben bereits erläutert, zeigt Fig. 3 für einen gegebenen ersten Stützpunkt, d.h. eine gegebene erste Lage 26S des Kraftangriffspunkts 26 zum Zeitpunkt $t_{Start}$ einer Bahnkurve 28 und für einen gegebenen zweiten Stützpunkt, d.h. eine gegebene zweite Lage 26E des Kraftangriffspunkts 26 zur Zeit $t_{Ende}$ der Bahnkurve 28, für einen gegebenen Drehwinkel α des Haupthebels 36 und für eine gegebene Drehachse 44 des Haupthebels 36 die Linie 48 aller zulässigen Gelenkpunkte, wobei 48S die Linie zum Zeitpunkt $t_{Start}$ und die Linie 48E die gleiche Linie 48 zum Zeitpunkt $t_{Ende}$, also nach Verdrehung des Haupthebels 36 um den Winkel α um die Drehachse 44 herum darstellt. Die Linie 48E ergibt sich einfach durch Verdrehen der Linie 48S um die Drehachse 44 herum um den Winkel α. Wie man die Linie 48S oder 48E erhält wird weiter unten noch anhand mehrerer Beispiele näher erläutert.

Fig. 3 verdeutlicht somit ein Konstruktionsverfahren zum Konstruieren einer Hebelkinematik 34, welche Hebelkinematik einen Haupthebel 36 und wenigstens eine Verbindungsstrebe 38 aufweist, wobei der Haupthebel 36 um eine Haupthebeldrehachse 44 um einen vorgegebenen Winkel α drehbar ist und wobei die Verbindungsstrebe 38 einen Kraftangriffspunkt 26 mit einem Gelenkknoten 42 an dem Haupthebel 36 verbindet, und wobei bei Beginn des Drehwinkels α eine erste Lage 26S und zu Ende des Drehwinkels eine zweite Lage 26E des Kraftangriffspunkts 26 vorgegeben ist, welches Konstruktionsverfahren den Schritt aufweist:

   a) Darstellen einer Linie 48, 48S, 48E der möglichen Gelenkpunkte 42 für den gegebenen Drehwinkel α, die Hauptachse 44 und die erste und die zweite Lage 26S, 26E des Kraftangriffspunkts 26.

Die Linie 48, 48S, 48E dient dann als Entscheidungshilfe oder Vorlage für die Auswahl möglicher Gelenkpunkte.

In der bevorzugten Ausgestaltung umfasst das Konstruktionsverfahren weiter noch den Schritt:

   b) Auswahl des Gelenkknotens 42 auf der Linie 48, 48S, 48E.

Wird der Gelenkknoten 42 auf der Linie 48 ausgewählt, kann hierzu der Haupthebel 36 zu Beginn und Ende des Drehwinkels α geometrisch dargestellt werden, wobei die Verbindungsstrebe 38 die Verbindung des Gelenkpunkts oder Gelenkknotens 42 zu Beginn und Ende des Drehwinkels α zu der ersten Lage 26S und der zweiten Lage 26E des Angriffspunktes 26 darstellt, wie dies dann in Fig. 3 angegeben ist.

So kann man anhand Fig. 3 gleich graphisch erkennen, ob die gewählten Kinematikpunkte 44, 42, 26S, 26E, 42S, 42E den Randbedingungen für die Konstruktion, wie sie beispielhaft oben wiedergegeben sind, genügen.

Demnach sind für das Konstruktionsverfahren zunächst der Drehwinkel α und der Drehpunkt 46 und eine erste Lage 26S und eine zweite Lage 26E des Kraftangriffspunkts 26 festzulegen.

Die Wahl der Lage 26S, 26E des Kraftangriffspunkts 26 ist z.B. durch eine gewünschte Bahnkurve 28, beispielsweise eine der Bahnkurven 28a-28d für die jeweilige Teilkinematik 34a-34d gemäß Fig. 1 vorgegeben.

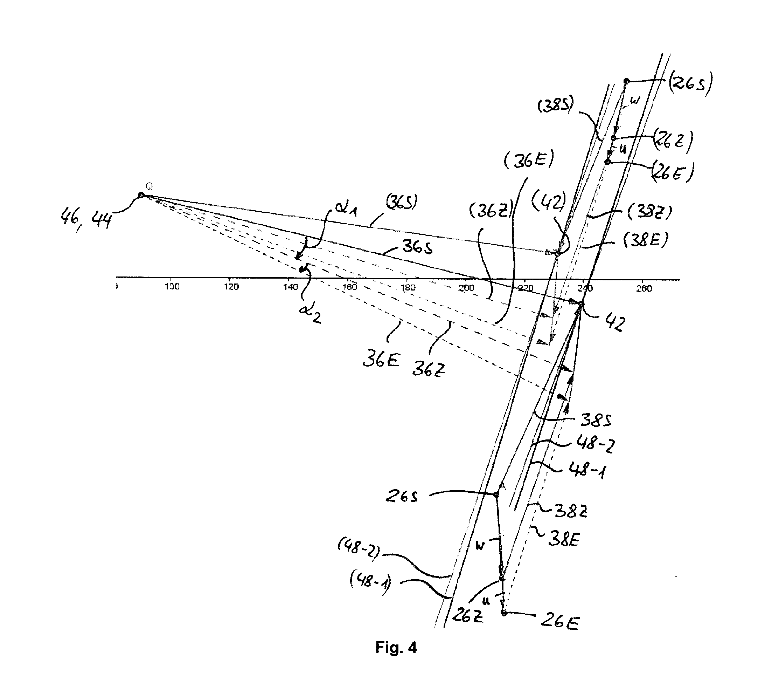

Es kann dabei sein, dass bei einer zu konstruierenden Hebelkinematik 34 nicht nur zwei Stützpunkte 26S, 26E der Bahnkurve 28 vorgegeben sind, sondern dass auch erwünscht ist, dass ein dritter Stützpunkt durch die Bewegung des Kraftangriffspunktes 26 angefahren wird. Beispielsweise ist, wie in Fig. 4 dargestellt, die Bewegung von einem ersten Stützpunkt zu einem zweiten Stützpunkt und weiter zu einem dritten Stützpunkt vorgegeben. Beispielsweise ist hier ein Startpunkt 26S für den Kraftangriffspunkt 26, eine Zwischenlage 26Z für den Kraftangriffspunkt 26 und eine Endlage 26E für den Kraftangriffspunkt 26 anzufahren. In einem solchen Fall werden die Isogonen 48 für eine Bewegung zwischen dem ersten Paar von Stützpunkten 26S, 26Z und einem ersten Teilwinkel $\alpha 1$ und die Isogonen 48 für eine Bewegung zwischen dem zweiten Paar von Stützpunkten 26Z, 26E und dem zweiten Teilwinkel $\alpha 2$ ermittelt. Als Gelenkpunkt 42 ist dann vorteilhaft der Schnittpunkt der so ermittelten Isogonen 48-1 und 48-2 auszuwählen.

In Fig. 4 sind hierzu zwei Beispiele angegeben, nämlich einmal für eine Schubstangenlösung wie sie bei den Teilkinematiken 34c und 34d von Fig. 1 zu realisieren wäre, und einmal für eine Zugstangenlösung, wie sie bei den Teilkinematiken 34a und 34b von Fig. 1 zu realisieren wäre. Die Bezugszeichen für die Zugstangenlösung sind dabei in Klammern wiedergegeben.

Falls die Bahnkurve 28 einer Teilkinematik 34 über mehr als zwei Stützpunkte 26S, 26Z, 26E, 26-1, 26-2,... definiert wird, können theoretisch beliebige Kombinationen von Stützpunkten 26S-26Z, 26S-26-1, ... als Start- und Endpunkte mit dazugehörigen Drehwinkel herangezogen und hierzu jeweils eine Isogone dargestellt werden.

Für das in Fig. 1 dargestellte Anwendungsbeispiel einer Konstruktion einer Lasteinleitungsstruktur für eine Steuerfläche eines Flugzeugs sind die Stützpunkte mit höchster Relevanz diejenigen für die Flugzustände "Cruise" 22 und "High-lift" 24, die aber nicht zwangsläufig Startpunkt 26S und Endpunkt 26E der Bahnkurve 28 sein müssen.

Bei gekoppelten Teil-Systemen wie zum Beispiel bei den Teil-Hebelkinematiken 34a-34d, sollte der Gelenkpunkt 42a, 42b der Verbindungsstrebe 38a-38d mit dem Schnittpunkt der Isogonen übereinstimmen, um keine strukturellen Zwangskräfte zu erzeugen. Als Voraussetzung sollten die Stützpunkte der einzelnen Bahnkurven 28a-28d zeitlich miteinander korrelieren. Insbesondere ist beim Beispiel von Fig. 1 ein Kriterium, Zwangskräfte in der Hautstruktur zu vermeiden.

Ist die angebundene Struktur 10 elastisch verformbar und sind Zwangskräfte weitgehend unkritisch, kann die Kinematik alleine durch relevante Stützpunkte (z.B. Start 26S und Ziel 26E und/oder Cruise 22 und High-lift 24) ausgelegt werden. Damit ergibt sich eine große Vielfalt an Kinematiklösungen, die durch weitere Kriterien eingeschränkt werden können.

Weitere Kriterien sind beispielsweise:

- gleiche Gelenkpunkte,
- gleiche Strebenlänge,
- Strebenausrichtung möglichst kollinear zur Kraftrichtung,
- ...

Zum Beispiel könnte die Bahnkurve 28 durch acht Punkte vorgegeben sein; es reicht aber bei einer elastischen angebundenen Struktur aus, hierfür alleine relevante Stützpunkte, nämlich z.B. die Endpunkte der Bahnkurve 28 zum Start 26S und zum Ende 26E anzugeben.

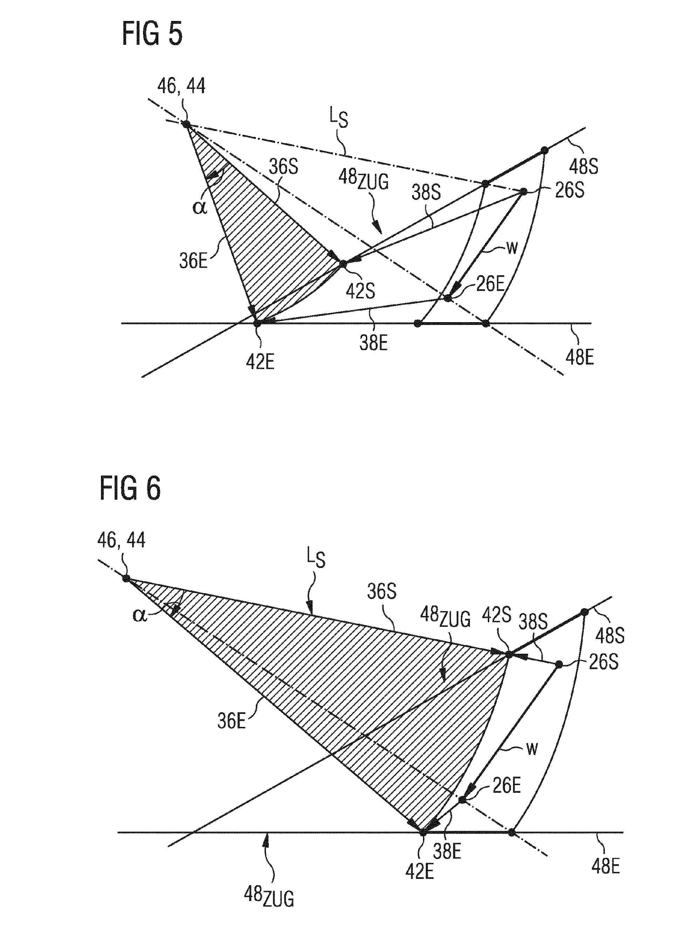

Ausgehend beispielsweise von Fig. 3 ergeben sich je nach Auswahl der Lage des Gelenkpunktes 42 auf der Isogonen 48 ganz unterschiedliche Kinematiklösungen. Mögliche Kinematiklösungen werden im Folgenden anhand der Darstellungen der Fig. 5 bis 12 näher erläutert.

In den Fig. 5 bis 12 sind hierbei gleich liegende Stützpunkte 26S und 26E bzw. gleiche Bahnkurven 28 anzufahren.

Bei den Fig. 5 bis 8 ist jeweils als Drehwinkel $\alpha$ ein Winkel von 29° im Uhrzeigersinn um die Drehachse 44 angegeben, wobei bei entsprechender Drehung des Haupthebels 36 um diesen Drehwinkel der Kraftangriffspunkt 26 sich vom Startpunkt 26S zum Endpunkt 26E bewegen soll. Die Vorgaben Drehwinkel, Lage der Drehachse, Startpunkt und Endpunkt sind somit bei allen in den Fig. 5 bis 8 gezeigten Lösungen die Gleichen; lediglich die Auswahl des Gelenkknotens 42 auf der Linie 48 unterscheidet sich.

Dabei zeigen die Fig. 5 und 6 Zugstreben, d.h. die Verbindungsstrebe 38 wird bei der Drehbewegung des Haupthebels 36 auf Zug belastet. Fig. 6 zeigt den Grenzfall, wo zum Startzeitpunkt $t_{Start}$ der Haupthebel 36 und die Verbindungsstrebe 38 auf einer Linie liegen. Die Grenze für die Auswahl des Gelenkpunktes 42 für eine Zugstrebenlösung bildet somit die direkte Linie $L_S$ zwischen Drehachse 44 und Startpunkt 26S, die in den Fig. 5 und 6 durch gestrichelte Linien dargestellt ist. Wählt man einen Gelenkpunkt 42 auf dem Bereich $48_{zug}$ der Isogone 48S aus, der sich vom Schnittpunkt zwischen der Isogone 48S der Verbindungslinie 44-26S ($L_S$) aus in Drehrichtung erstreckt, erhält man eine Zugstrebenlösung.

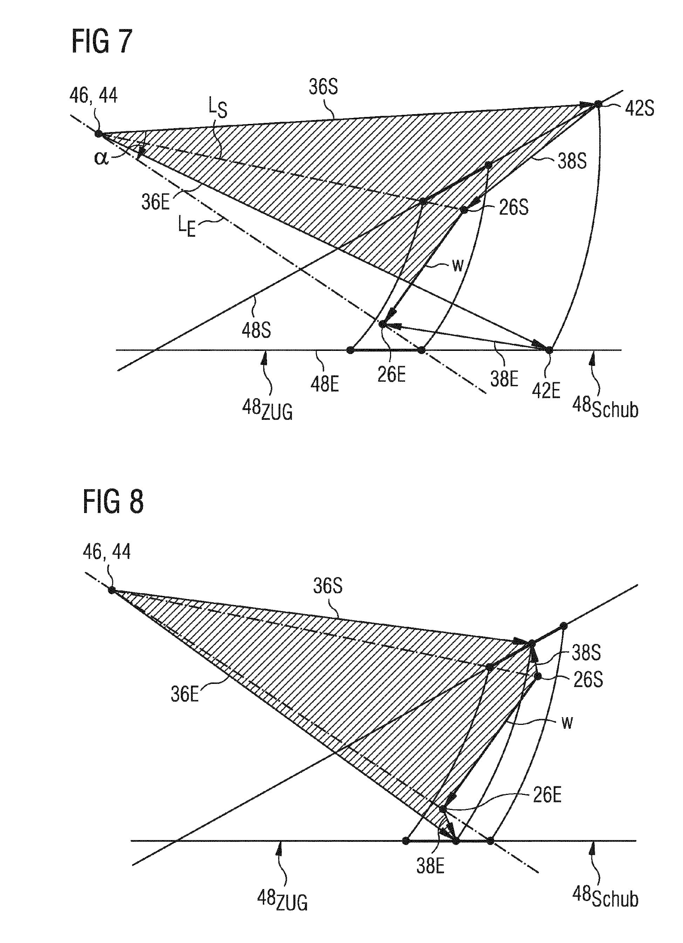

Die Fig. 7 zeigt dagegen eine Schubstrebenlösung. Zur Auswahl von Schubstrebenlösungen ist es vorteilhaft, den Gelenkpunkt 42 auf der Isogone 48E zum Ende der Drehbewegung auszuwählen, und zwar auf dem Bereich $48_{Schub}$ dieser Isogone 48E, der sich von dem Schnittpunkt dieser Isogone 48E mit der durch den Drehpunkt 46 und den Endpunkt 26E geführten Verbindungsgeraden $L_E$ aus entgegen der Drehrichtung erstreckt.

Fig. 8 zeigt eine Auswahl des Gelenkpunktes 42 auf einem zwischen dem Bereich $48_{Zug}$ für die Zugstrebenlösung und dem Bereich $48_{Schub}$ für die Schubstrebenlösung liegenden Bereich $48_Z$ der Isogonen 48. Hier würde im Verlauf der Drehbewegung um den Winkel $\alpha$ ein Wechsel von einer Schubbelastung zu einer Zugbelastung erfolgen;

eine solche Lösung ist in den meisten Fällen ungünstig.

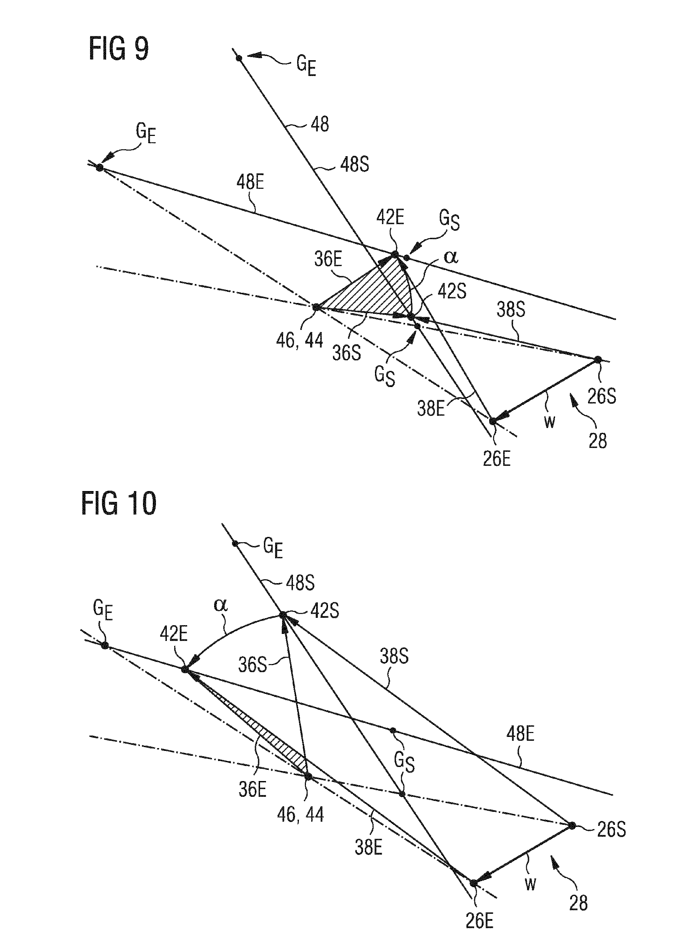

Wie die Fig. 9 zeigt, müssen sich jedoch der Haupthebel 36 und der Kraftangriffspunkt 26 nicht zwangsläufig in der gleichen Richtung bewegen; hier ist eine Lösung gezeigt, wo die Bahnkurve 28 (angedeutet durch den direkten Verbindungsvektor w zwischen Startpunkt 26S und Endpunkt 26E) von rechts oben nach links unten reicht, während sich der Haupthebel 36 entgegen dem Uhrzeigersinn, also von rechts unten nach links oben bewegt. Zwischen dem Grenzfall $G_S$ eines gestreckten Gestänges bei der Startposition und dem Grenzfall $G_E$ eines gestreckten Gestänges bei der Zielposition können sich zulässige Zugstrebenlösungen befinden, von denen Beispiele in Fig. 9 und 10 dargestellt sind.

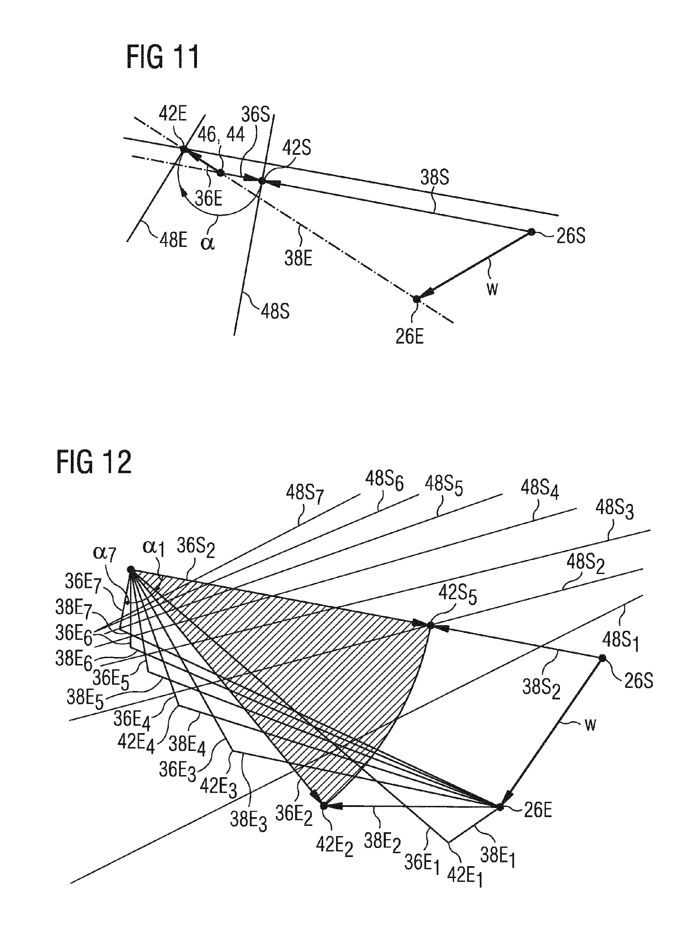

Fig. 11 zeigt, dass auch Drehwinkel > 180° möglich sind. In Fig. 11 ist ein Beispiel einer Lösung gezeigt, bei der das Gestänge 36-38 bei Startposition und bei Zielposition gestreckt ist.

Es kann auch eine Hebelkinematik 34 konstruiert werden, bei der sich die Bewegungsbahn 28 parallel zu dem Haupthebel 36 und der Verbindungsstrebe 38 zum Startzeitpunkt erstrecken kann.

Fig. 12 zeigt, wie sich die Lage der Isogone 48 für unterschiedliche Drehwinkel $\alpha$ verändert. Hier sind die Isogonen $48S_1$ bis $48S_7$ für gleiche Start- und Endpunkte 26S und 26E aber für sieben unterschiedliche Drehwinkel $\alpha_1$ bis $\alpha_7$ dargestellt.

Im Folgenden wird eine Möglichkeit einer Konstruktion einer gekoppelten Gesamthebelkinematik 18, wie sie z.B. in Fig. 1 gezeigt ist, erläutert.

Eine mögliche Vorgehensweise zur Auslegung eines gekoppelten Kinematiksystems 18 ist wie folgt:

Die Reihenfolge, in der die Teilkinematiken 34a-34d ausgelegt werden, ist ausgehend von der besonders kritischen, bzw. baulich schwierig lösbaren Teilkinematik zur Einfacheren. Die erste Teilkinematik übernimmt die "Master"-Funktion für die weiteren "Slave"-Teilkinematiken. Der "Master" bestimmt die Drehwinkel der einzelnen zeitlich korrelierten Stützpunkte 26S, 26E der Bahnkurve 28, 28a-28d bestimmt. Mit den vorgegebenen Drehwinkeln können nun zu ausgewählten Stützpunkten einer einzelnen "Slave"-Teilkinematik die entsprechenden Isogonen dargestellt werden. Werden mehr als zwei Stützpunkte berücksichtigt, können mehr als eine Isogone dargestellt werden. Deren gemeinsamer Schnittpunkt beschreibt den idealen Gelenkpunkt.

In Fig. 1 könnte beispielsweise die Teilkinematik 34a am schwierigsten sein, da hier am ehesten ein Wechsel von Schubbelastung auf Zugbelastung mit der Gefahr eines Umklappens zu befürchten ist. Diese könnte somit die Masterfunktion erfüllen.

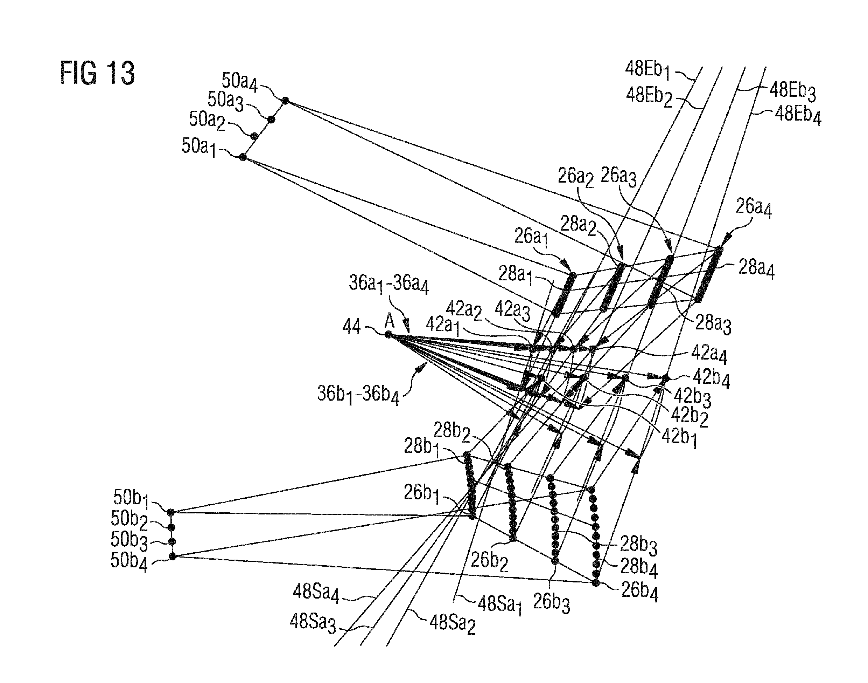

Eine weitere Konstruktion ist in Fig. 13 dargestellt; hier ist eine Lösung für eine flexible Hautstruktur 10 einer gepfeilten Flügelvorderkante dargestellt, wobei vier in Spannweitenrichtung aufeinanderfolgende Hebelkinematikstationen $18_1$ bis $18_4$ (Schnitte durch die Flügelvorderkante) mit jeweils zwei Kraftangriffspunkten $26a_1$ bis $26a_4$ und $26b_1$ bis $26b_4$ zu konstruieren sind. Der Punkt A stellt die gemeinsame Drehachse 44 für die Haupthebel $36a_1$ bis $36a_4$ und $36b_1$ bis $36b_4$ dar. Bei $50a_1$ bis $50a_4$ sind die angenäherten Kreismittelpunkte für die Bewegungsbahnen $28a_1$ bis $28a_4$ der ersten Kraftangriffspunkte $26a_1$ bis $26a_4$ und bei $50b_1$ bis $50b_4$ sind die angenäherten Kreismittelpunkte für die Bewegungsbahnen $28b_1$ bis $28b_4$ der zweiten Kraftangriffspunkte $26b_1$ bis $26b_4$ dargestellt. Auch hier geht man entsprechend, wie zuvor erläutert, von der schwierigsten Teilkinematiklösung zu der einfacheren Teilkinematiklösung vor. Weiter sind Isogonen $48Sa_1$ bis $48Sa_4$ für die ersten Teilkinematiken für die ersten Kraftangriffspunkte $26a_1$ bis $26a_4$ zum Startzeitpunkt $t_{Start}$ und Isogonen $48Eb_1$ bis $48Eb_4$ für die zweiten Teilkinematiken für die zweiten Kraftangriffspunkte $26b_1$ bis $26b_4$ dargestellt, auf denen dann ideale Gelenkpunkte $42a_1$ bis $42a_4$ bzw. $42b_1$ bis $42b_4$ auszuwählen sind.

Durch die Darstellung der Isogonen 48 lässt sich Schritt für Schritt zu jedem Teilkinematikproblem ein entsprechender Gelenkpunkt 42 finden, wobei die Lösung gleich graphisch anschaulich ist und der Konstrukteur, wie voranstehend anhand der unterschiedlichen Beispiele unterschiedlicher ausgewählter Gelenkpunkte, gleich die Eignung der ausgewählten Lösung abschätzen kann.

Mit entsprechenden Graphik-Programmen oder Mathematik-Programmen, welche einfache geometrische Figuren anschaulich darstellen können, lässt sich sehr schnell für unterschiedlich ausgewählte Gelenkpunkte die entsprechende Hebelkinematik aufzeigen. Hierzu können dynamische Geometrie-Software-Programme verwendet werden, wie sie für den Mathematik-Unterricht zur Verfügung stehen. Mit dynamischer Geometrie-Software kann man interaktiv geometrische Konstruktionen am Computer erstellen. Derartige Programme sind als Freeware im Internet herunterladbar; beispielsweise können hierzu die Programme "Derive", "Mathcad", "Cinderella", "Geonext" oder "GeoGebra". Hierzu können leicht Hilfsalgorythmen geschrieben werden, um auf Basis eines dieser Programme ein Programm zur Darstellung der Isogonen zu entwickeln, mit dessen Hilfe die ausgewählten Konstruktionen gleich angezeigt werden können.

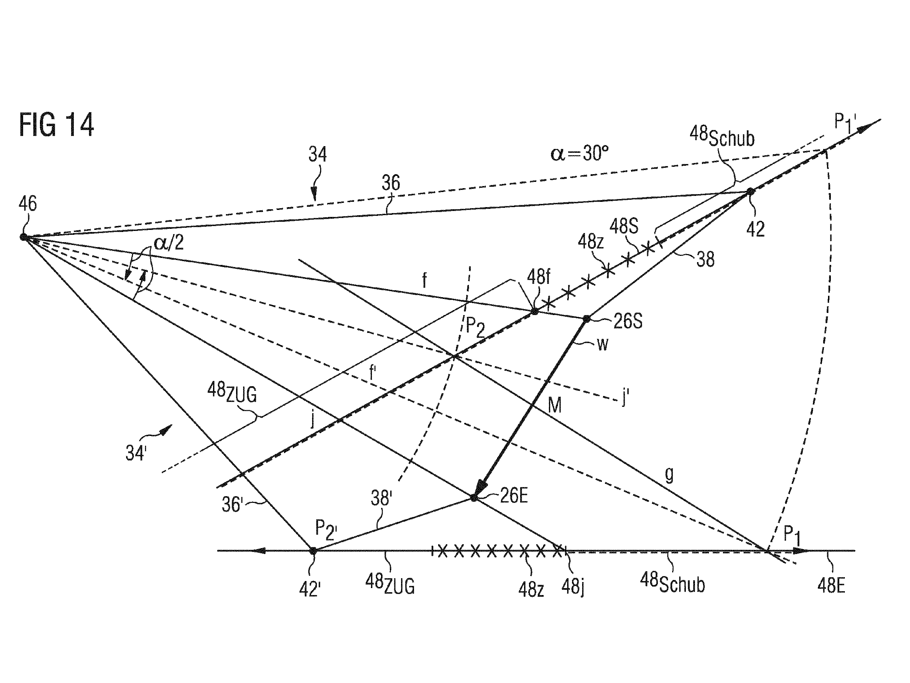

Die Darstellung der hier als "Isogonen" bezeichneten Linien 48 aller möglichen Gelenkpunkte 42 für die vorgegebenen Parameter Drehwinkel, Drehachse, Startpunkt und Endpunkt ist auf unterschiedliche Art und Weise möglich. Im Folgenden wird eine erste mögliche Ausführungsform anhand der Darstellung in Fig. 14 näher erläutert. Dabei soll dann, wenn der Haupthebel 36 sich um einen Winkel $\alpha$ (hier ca. 30°) in Uhrzeigerrichtung um den Drehpunkt 46 gedreht wird, eine Bewegung des Kraftangriffspunkts 26 vom Startpunkt 26S zum Endpunkt 26E durchgeführt werden.

Hierzu werden, beispielsweise mit einem der zuvor erläuterten Software-Programme, zunächst der Drehpunkt 46 sowie der Anfangspunkt 26S und der Endpunkt 26E in der xy-Ebene festgelegt. In dem nun folgenden Beispiel sei der Drehwinkel beispielsweise 30° im Uhrzeigersinn.

Anschließend wird der Vektor w von dem Punkt 26S zu dem Punkt 26E, sowie die Gerade f durch den Drehpunkt 46 und den Anfangspunkt 26S, die Gerade g durch den Mittelpunkt M des Vektors w und senkrecht zu dem Vektor w in der xy-Ebene und die Gerade j durch den Drehpunkt 46 und den Endpunkt 26E eingezeichnet.

Anschließend wird die Gerade f um den Drehpunkt 46 in Drehrichtung um den Winkel $\frac{\alpha}{2}$ gedreht, was die Gerade f' ergibt. In vergleichbarer Weise wird die Gerade j um den Drehpunkt 46 in Gegenrichtung um den halben Drehwinkel $\frac{\alpha}{2}$ gedreht, was die Gerade j' ergibt. Der Schnittpunkt zwischen f' und g wird als z.B. $P_1$ bezeichnet, der Schnittpunkt zwischen j' und g wird als z.B. $P_2$ bezeichnet.

Anschließend wird der Punkt $P_1$ um - $\alpha$, d.h. um $\alpha$ in Gegendrehrichtung, gedreht, was den Punkt $P_1$' ergibt. Der Punkt $P_2$ wird um den Drehwinkel $\alpha$ in Drehrichtung gedreht, was den Punkt $P_2$' ergibt.

Punkt $P_2$ ist einer der möglichen Gelenkpunkte, wenn sich das System am Anfangszeitpunkt befindet. $P_1$ ist einer der möglichen Gelenkpunkte, wenn sich das System am Endzeitpunkt befindet. Die Isogone 48S zum Anfangszeitpunkt ergibt sich somit als eine Gerade durch den Punkt $P_2$ und den gedrehten Punkt $P_1$', während sich die Isogone 48E durch eine Gerade durch den Punkt $P_1$ und den um $\alpha$ gedrehten Punkt $P_2$' ergibt.

Die vorgenannte Konstruktion der Isogonen 48S, 48E beruht auf der Überlegung, dass die Gerade g die Summe aller Punkte darstellt, die den gleichen Abstand zu 26S und 26E haben. Wenn der halbe Drehwinkel vollendet ist und dann ein Punkt erreicht ist, der zu dem Anfangspunkt 26S den gleichen Abstand wie zu dem Endpunkt 26E hat, dann ist dies ein möglicher Punkt für einen Gelenkknoten. Genauso ist im Punkt $P_2$ noch der halbe Drehwinkel durchzuführen; andererseits liegt der Punkt $P_2$ genau gleich weit entfernt von dem Anfangspunkt 26S und dem Endpunkt 26E. Daher sind die Punkte $P_1$ und $P_2$ mögliche Gelenkpunkte für den Anfangszustand bzw. den Endzustand. Entsprechende Drehungen um den Winkel $\alpha$ ergeben dann einen weiteren möglichen Gelenkpunkt für den Endzustand bzw. den Anfangszustand.

Die vorliegende Darstellung der Isogonen 48 gemäß Fig. 14 beruht also auf einer Überlegung der Achsensymmetrie. Auch andere geometrische Konstruktionen sind möglich, z.B. mit Hilfe von Ellipsen-Tangenten oder Hyberbel-Tangenten. Auch numerische Lösung von jeweils zwei Punkten auf der Isogonen sind möglich, um so die Isogonen 48 entsprechend darstellen zu können.

Hat man nun die Isogonen 48E, 48S, wie in Fig. 14 gezeigt, dargestellt, gilt es noch, den geeigneten Gelenkpunkt 42 auf den Isogonen 48E, 48S auszuwählen.

Hierzu können zunächst Überlegungen, ob eine Schubstrebe oder eine Zugstrebe gewünscht ist, erfolgen.

Die Gerade f stellt einen Fall eines gestreckten Gestänges - Haupthebel 36 und Verbindungsstrebe 38 auf einer Linie - am Startpunkt 26S dar. Demnach ist der Schnittpunkt 48f der Geraden f mit der Isogone 48S der Ort für den Gelenkpunkt 42 für diesen Grenzfall einer Zugstrebenlösung.

Die Gerade j stellt den Grenzfall eines gestreckten Gestänges - Haupthebel 36 und Verbindungsstrebe 38 auf einer Linie - für den Endpunkt 26E dar. Demnach stellt der Schnittpunkt 48j der Geraden j mit der Isogone 48E für diesen Endzustand den Grenzfall für einen zulässigen Gelenkpunkt 42 für die Schubstrebenlösung dar. Die mit zusätzlichen gestrichelten Linien gekennzeichneten Bereiche $48_{Zug}$ und $48_{Schub}$ sind somit mögliche Lagen von Gelenkpunkten 42 für eine Schubstrebenlösung bzw. eine Zugstrebenlösung. Der Bereich $48_Z$ dazwischen sollte vermieden werden. Dies ist in Fig. 14 durch Kreuze in dem Bereich $48_Z$ dargestellt.

In Fig. 14 sind nun zwei mögliche Lösungen für die Hebelkinematik 34, 34' eingezeichnet, wobei bei der Hebelkinematik 34 mit dem Hebel 36, dem Gelenkpunkt 42 und der Verbindungsstrebe 38 eine Schubstrebenlösung ausgewählt worden ist und in der Anfangsstellung dargestellt ist und bei der Hebelkinematik 34' mit dem Haupthebel 36', dem Gelenkpunkt 42' und der Verbindungsstrebe 38' eine Zugstrebenlösung in der Stellung am Ende der Bewegung dargestellt ist. Bei beiden Hebelkinematiken 34, 34' ergibt eine Drehung des Haupthebels 36, 36' um den Drehwinkel $\alpha$ (hier 30°) im Uhrzeigersinn um den gemeinsamen Drehpunkt 46 eine Bewegung des Kraftangriffspunktes 26 aus der Anfangsstellung 26S zu der Endstellung 26E.

Voranstehend sind Lösungen zum Konstruieren von Hebelkinematiken erläutert worden, wobei die Hebel und die Verbindungsstrebe und auch die Bewegung in einer Ebene liegen. Darauf ist die Erfindung aber nicht beschränkt. Die Lösung mit Isogonen lässt sich auch für dreidimensionale Kinematikprobleme verwenden, wie dies hiernach noch näher dargestellt wird.

Der in der Konstruktion gemäß der Fig. 14 gewählte Ansatz der Herleitung und Darstellung der Isogonen 48 verwendet Überlegungen über die Achsensymmetrie. Hintergedanke dabei ist, dass die Länge der Verbindungsstrebe 38 stets gleich ist und man so die Länge der Verbindungsstrebe 38 am Anfangspunkt 26S und am Endpunkt 26E über Achsensymmetrie spiegelt.

Demnach wird anhand der Vorgaben, nämlich die beiden Kraftangriffspunkte und der Ort der Hauptdrehachse A eine Senkrechte auf die Verbindung zwischen den beiden Kraftangriffspunkten 26S und 26E konstruiert.

Hintergedanke der Konstruktion ist, dass dann, wenn man die Achsen jeweils um $\alpha/2$, also den halben Drehwinkel, spiegelt, jeweils links und rechts die gleiche Länge der Verbindungsstrebe 38 gegeben sein muss. Mit diesem Konstruktionsprinzip kann man die Isogonen für den Start 48S (das ganze System befindet sich im Startpunkt) und für das Ziel 48E (das ganze System befindet sich im Zielpunkt) konstruieren.

Es wird somit die Symmetrie zu den Achsen ausgenutzt. Es werden Achsen definiert, wo die Punkte gleicher Länge gegeben sind. Wo sich diese schneiden, befindet sich die Isogone.

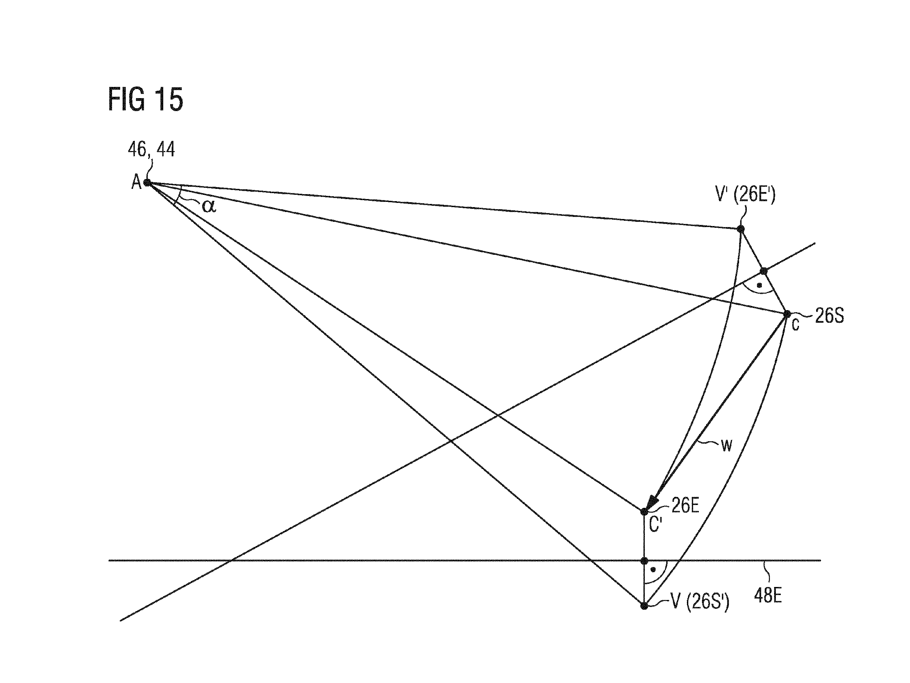

Im Folgenden wird anhand der Darstellung in Fig. 15 noch ein alternativer und viel einfacherer und damit bevorzugter Weg zur Darstellung der Isogonen 48 erläutert. Hierzu wird eine Mittelsenkrechten-Konstruktion verwendet. Das Koordinatensystem wird hierzu vorzugweise derart gewählt, dass die Drehebene des Haupthebels und die Ebene der Verbindungsknoten (insbesondere Kraftangriffspunkte) in der xy-Ebene liegen, mit der Drehachse im Ursprung (0, 0).

Fig. 15 zeigt die gegebene Ausgangssituation mit einem Drehwinkel $\alpha$ (hier z.B. - 29°, der Drehebene (xy-Ebene), dem Drehpunkt 46 (A) und den Bahnpunkten zum Start 26S und zum Ende 26E (C und C') zusammen mit dem Vektor w.

In einem ersten Schritt wird der Punkt C - Startpunkt 26S -um den Drehpunkt 46 herum um den Winkel $\alpha$ (z.B. -29°) gedreht. Der sich dadurch ergebende Punkt ist in Fig. 15 als V bezeichnet. Die Mittelsenkrechte auf die Verbindungslinie C'V wird konstruiert; diese Mittelsenkrechte bildet die Isogone 48E zum Ende der Bewegung (Isogone der Zielposition).

Die Isogone 48S zum Beginn lässt sich dann auch einfach durch Drehen der Isogone 48E um den Drehpunkt 46 um den Winkel -$\alpha$ erhalten.

Man kann aber auch den Punkt C' - Endpunkt 26E - um den Drehpunkt 46 herum um den Winkel - $\alpha$ (29°) drehen. Der sich ergebende Punkt ist in Fig. 15 als V' bezeichnet. Anschließend wird die Mittelsenkrechte zur Verbindungslinie C-V' konstruiert. Diese Mittelsenkrechte bildet die Isogone zum Anfang der Bewegung 48S (Isogone der Startposition).

Dieser Konstruktion liegt folgender Hintergedanke zugrunde: Die Mittelsenkrechte zu einer Verbindungslinie zwischen zwei Referenzpunkten stellt die Menge aller Punkte dar, die zu den Referenzpunkten den gleichen Abstand haben. Die Mittelsenkrechte zu C'-V stellt somit die Menge aller Punkte dar, die zu dem Zielpunkt C' und dem um $\alpha$ gedrehten Startpunkt V den gleichen Abstand haben. Punkte mit gleichem Abstand zu dem Zielpunkt und dem gedrehten Startpunkt sind aber unmittelbar die möglichen Gelenkpunkte 42. Somit erhält man sehr einfach und universell die Isogonen 48.

Beschrieben wird im Folgenden noch die dreidimensionale Lösung. Entsprechend wie zuvor für die zweidimensionale Lösung kann man die Isogonen auch auf unterschiedliche Arten erhalten. Basierend auf der Lösung der Mittelsenkrechten ergibt sich ein erster Fall der universell anwendbar ist. Der auf den Überlegungen der Fig. 14 basierende zweite Lösungsweg geht nur für den folgenden zweiten Fall, bei dem die Strecke 26S-26E nicht orthogonal zur Drehebene, d.h. nicht parallel zur Drehachse ist. Dieser zweite Lösungsweg ist nicht auf Fälle anwendbar, wo die Verbindungslinie 26S-26E ist orthogonal zur Drehebene, d.h. parallel zur Drehachse ist.

Im universellen Lösungsweg (Fall 1) kann das Prinzip der Mittelsenkrechten angewandt werden. Im anderen Lösungsweg (Fall2) kann das gleiche Prinzip der Achsensymmetrie zur Herleitung der Isogonen 48S und 48E angewandt werden. Man erhält so Schnittgeraden. Die entsprechenden Lösungen sind die Schnittpunkte der Schnittgeraden mit der Drehebene i.

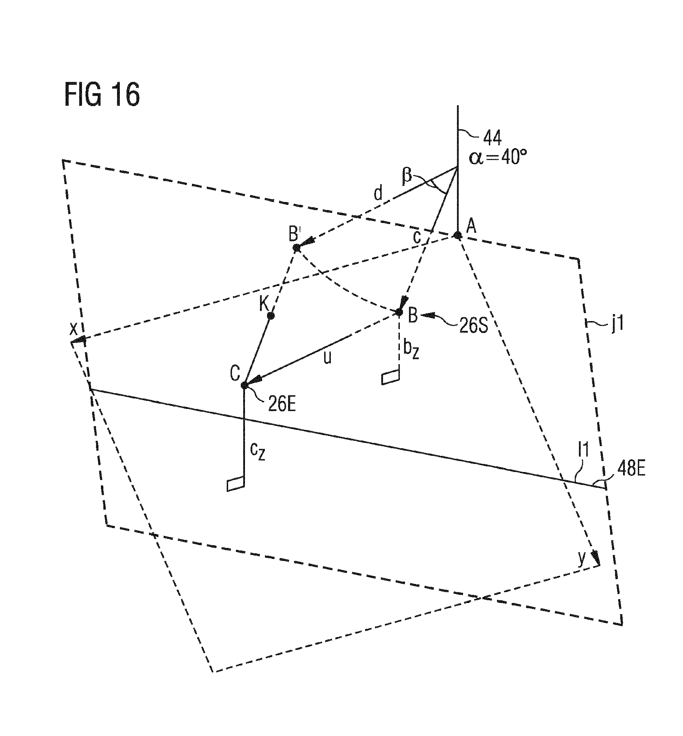

Der einfachere Weg zur Konstruktion der Isogonen im 3D-Fall, der für alle 3D-Fälle einschließlich des orthogonalen Falls und auch - wie in Fig. 15 gezeigt - im 2D-Fall anwendbar ist, wird im Folgenden anhand der Darstellungen in den Fig. 16 bis 18 erläutert. Die Fig. 16 bis 18 zeigen Konstruktionen, die mit Hilfe eines Geometrieprogrammes entworfen worden sind, wobei die Schritte und Definitionen der Tabelle 1 gewählt worden sind

## Tabelle 1 – Fall 1

| Nr. | Name | Definition | Befehl |
|---|---|---|---|
| 1 | Winkel α | | |
| 2 | Winkel η | | |
| 3 | Zahl h | | |
| 4 | Punkt H | (0, 0, h) | (0, 0, h) |
| 5 | Ebene i | Ebene durch H normal auf zAchse | OrthogonalPlane[H, zAchse] |
| 6 | Punkt A | | |
| 7 | Punkt B | | |
| 8 | Punkt C | | |
| 9 | Gerade e | Linie im 3D Raum durch C, schneidet und ist senkrecht zu zAchse | Senkrechte[C, zAchse, Raum] |
| 10 | Punkt E | Schnittpunkt von zAchse, e | Schneide[zAchse, e] |
| 11 | Gerade $r_1$ | Gerade durch B senkrecht zu i | Senkrechte[B, i] |
| 12 | Gerade $s_1$ | Gerade durch C senkrecht zu i | Senkrechte[C, i] |
| 13 | Punkt M | Schnittpunkt von $r_1$, i | Schneide[$r_1$, i] |
| 14 | Strecke $b_2$ | Strecke [B, M] | Strecke[B, M] |
| 15 | Winkel δ | Winkel zwischen $r_1$, i | Winkel[$r_1$, i] |
| 16 | Punkt N | Schnittpunkt von $s_1$, i | Schneide[$s_1$, i] |
| 17 | Strecke $c_2$ | Strecke [C, N] | Strecke[C, N] |
| 18 | Winkel γ | Winkel zwischen $s_1$, i | Winkel[$s_1$, i] |
| 19 | Vektor u | Vektor[B, C] | Vektor[B, C] |
| 20 | Gerade b | Linie im 3D Raum durch B, schneidet und ist senkrecht zu zAchse | Senkrechte[B, zAchse, Raum] |
| 21 | Punkt D | Schnittpunkt von zAchse, b | Schneide[zAchse, b] |
| 22 | Vektor c | Vektor[D, B] | Vektor[D, B] |
| 23 | Punkt B' | B gedreht um Winkel -α um zAchse | Drehe[B, -α, zAchse] |
| 24 | Vektor d | Vektor[D, B'] | Vektor[D, B'] |
| 25 | Winkel β | Winkel zwischen B, D, B' | Winkel[B, D, B'] |
| 26 | Bogen g | Kreisbogen[D, B, B'] | Kreisbogen[D, B, B'] |
| 27 | Strecke v | Strecke [C, B'] | Strecke[C, B'] |
| 28 | Punkt K | Mittelpunkt von C, B' | Mittelpunkt[C, B'] |
| 29 | Ebene $j_1$ | Ebene durch K normal auf v | OrthogonalPlane[K, v] |
| 30 | Gerade $l_1$ | Schnittgerade von $j_1$, i | SchneideBahnkurven[$j_1$, i] |
| 31 | Punkt C' | C gedreht um Winkel α um zAchse | Drehe[C, α, zAchse] |
| 32 | Vektor s | Vektor[E, C'] | Vektor[E, C'] |
| 33 | Vektor f | Vektor[E, C] | Vektor[E, C] |
| 34 | Bogen k | Kreisbogen[E, C', C] | Kreisbogen[E, C', C] |
| 35 | Winkel ζ | Winkel zwischen s, f | Winkel[s, f] |
| 36 | Strecke t | Strecke [C', B] | Strecke[C', B] |
| 37 | Punkt L | Mittelpunkt von C', B | Mittelpunkt[C', B] |
| 38 | Ebene $o_1$ | Ebene durch L normal auf t | OrthogonalPlane[L, t] |
| 39 | Gerade $q_1$ | Schnittgerade von i, $o_1$ | SchneideBahnkurven[i, $o_1$] |
| 40 | Punkt F | Punkt auf $q_1$ | Punkt[$q_1$] |
| 41 | Vektor w | Vektor[A, F] | Vektor[A, F] |
| 42 | Vektor w' | w gedreht um Winkel -α um zAchse | Drehe[w, -α, zAchse] |
| 43 | Punkt F' | F gedreht um Winkel -α um zAchse | Drehe[F, -α, zAchse] |
| 44 | Winkel ε | Winkel zwischen w, w' | Winkel[w, w'] |
| 45 | Bogen p | Kreisbogen[A, F, F'] | Kreisbogen[A, F, F'] |
| 46 | Vektor a | Vektor[F, B] | Vektor[F, B] |
| 47 | Vektor j | Vektor[F', C] | Vektor[F', C] |
| 48 | Zahl abstandF'C | Abstand zwischen F' und C | Abstand[F', C] |
| 49 | Text TextF'C | "" + (Name[F'] + (Name[C])) + " = " + (Name[F] + (Name[B])) + "" | "" + (Name[F'] + (Name[C])) + " = " + (Name[F] + (Name[B])) + "" |
| 50 | Zahl abstandFB | Abstand zwischen F und B | Abstand[F, B] |

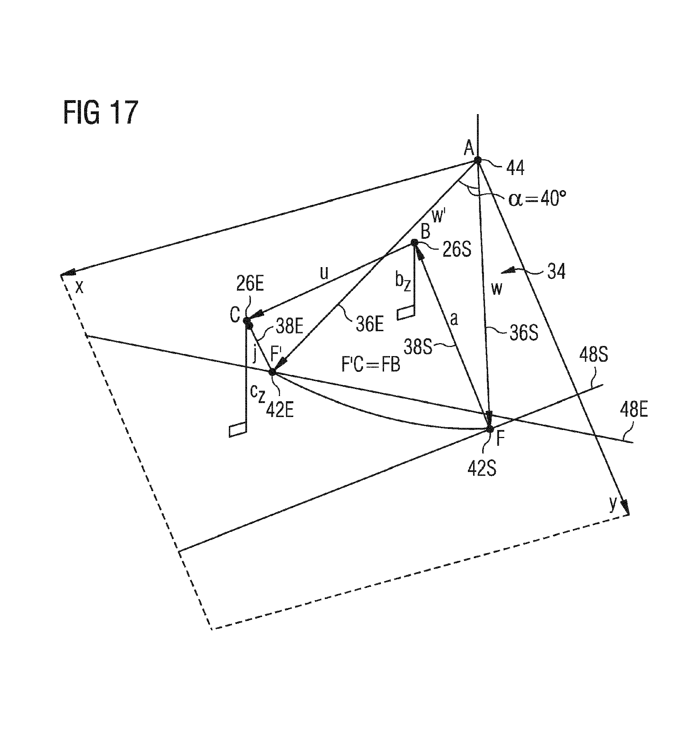

Bei dem Verfahren zur Bestimmung der Isogonen für den allgemeinen 3D Fall (gültig auch für 2D) gemäß Fig. 16 und 17 kann die Verbindungslinie der Bahnpunkte zur Drehebene beliebig angeordnet (sowohl nicht senkrecht als auch senkrecht zueinander) sein.

Voraussetzung ist eine Koordinatentransformation, damit

- die Drehachse des Haupthebels gleich der z-Achse entspricht,

- der Drehpunkt im Ursprung (0,0,0) liegt,
- die Ebene der Verbindungsknoten auf der xy-Ebene oder parallel dazu angeordnet ist.

Bei der gegebenen Ausgangssituation sind der beispielhafte Drehwinkel alpha (=40°), die Drehebene (xy-Ebene), Drehachse (z-Achse), der Drehpunkt (A), und die Bahnpunkte zum Start und Ende (B = 26S und C = 26E) dargestellt.

Es folgt Schritt 1: Konstruktion des Mittelpunkts K

- B': Drehung des Punktes B um Winkel -alpha
- K: Mittelpunkt zwischen B' und C

Fig. 16 zeigt Schritt 2: Konstruktion der ersten Isogone l1

- j1: Normalenebene durch K mit Normalenvektor v
  = Symmetrieebene zwischen B' und C
- Iso-Gerade l1 : Schnittlinie zwischen j1 und Drehebene i (hier identisch mit xy-Ebene)

Die Iso-Gerade l1 stellt die Isogone 48E zum Endzeitpunkt $t_{Ende}$ dar. Die Isogone 48S lässt sich einfach durch Drehen der Linie 48E um -alpha um die Drehachse (=z-Achse) erhalten.

Man kann auch Schritt 3 durchführen: Konstruktion des Mittelpunkts L

- C': Drehung des Punktes C um Winkel alpha
- L: Mittelpunkt zwischen B und C'

und anschließend Schritt 4: Konstruktion der zweiten Isogone q1

- o1: Normalenebene durch L mit Normalenvektor t
  = Symmetrieebene zwischen B und C'
- Iso-Gerade q1: Schnittlinie zwischen o1 und Drehebene i (hier identisch mit xy-Ebene)

Fig. 17 zeigt eine Auswahl eines beliebigen Punktes (F) als Gelenkpunkt 42S auf der Isogonen 48S und Drehung um alpha (F') - Gelenkpunkt 42E. Hierdurch erhält man eine mögliche Kinematik 34 bei der gegebenen Ausgangssituation.

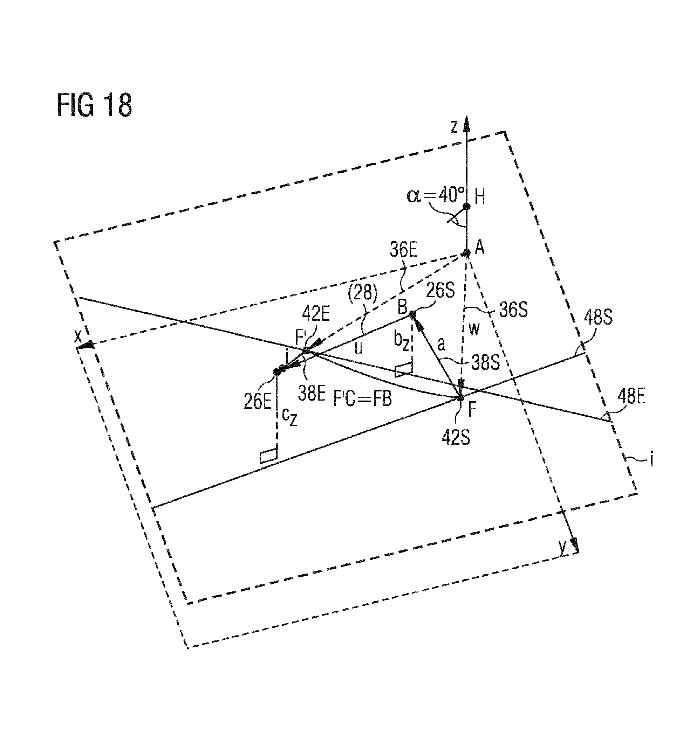

In Fig. 18 ist beispielhaft folgende zu Fig. 17 abweichende Ausgangssituation angenommen: Drehwinkel alpha (=40°), die Drehebene i verläuft parallel zur xy-Ebene durch H, Drehachse ist die z-Achse, Drehpunkt (A) bzw. Lager des Haupthebels verläuft durch den Ursprung, weiter sind die Bahnpunkte 26S, 26E am Start und am Ende gezeigt (B und C).

Die Konstruktion erfolgt wie zuvor beschrieben, jedoch schneiden die Ebenen o1 und j1 nicht die xy-Ebene sondern die Drehebene i, die parallel zur xy-Ebene und durch den Punkt H verläuft.

Fig. 18 zeigt die fertige Konstruktion vergleichbar zu Fig. 17 bei der entsprechend geänderten Ausgangssituation in einer Perspektive mit der Ebene i.

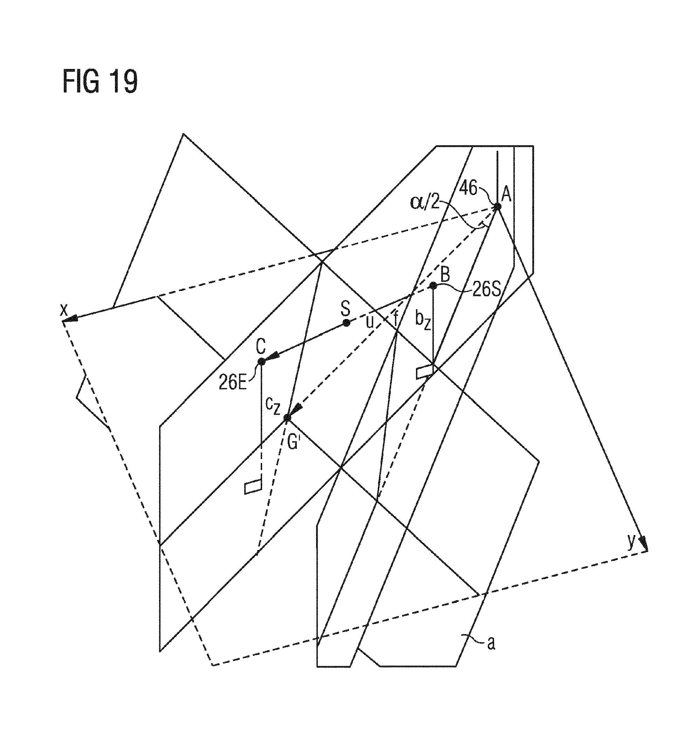

Im Folgenden wird anhand der Darstellung in Fig. 19 bis 21 der Fall2 erläutert. In Tabelle 2 sind hierzu die einzelnen durch ein Geometrieprogramm durchgeführten Schritte zusammen mit den Definitionen der in Fig. 19 bis 21 dargestellten Punkte, Linien und Ebenen zusammengestellt.

Tabelle 2 - Fall 2

| Nr. | Name | Definition | Befehl |
|---|---|---|---|
| 1 | Winkel $\alpha$ | | |
| 2 | Zahl h | | |
| 3 | Punkt A | | |
| 4 | Ebene i | Ebene durch A normal auf zAchse | OrthogonalPlane[A, zAchse] |
| 6 | Punkt B | | |
| 7 | Gerade $b_1$ | Gerade durch B senkrecht zu i | Senkrechte[B, i] |
| 8 | Punkt E | Schnittpunkt von $b_1$, i | Schneide[$b_1$, i] |

(fortgesetzt)

| Nr. | Name | Definition | Befehl |
|---|---|---|---|
| 9 | Strecke $b_z$ | Strecke [B, E] | Strecke[B, E] |
| 10 | Winkel $\gamma$ | Winkel zwischen $b_z$, i | Winkel[$b_z$, i] |
| 11 | Punkt C | | |
| 12 | Gerade g | Gerade durch C senkrecht zu i | Senkrechte[C, i] |
| 13 | Punkt D | Schnittpunkt von g, i | Schneide[g, i] |
| 14 | Strecke $c_z$ | Strecke [C, D] | Strecke[C, D] |
| 15 | Winkel $\beta$ | Winkel zwischen $c_z$, i | Winkel[$c_z$ i] |
| 16 | Vektor v | Vektor[A, C] | Vektor[A, C] |
| 17 | Vektor u | Vektor[B, C] | Vektor[B, C] |
| 18 | Punkt S | Mittelpunkt von C, B | Mittelpunkt[C, B] |
| 19 | Ebene a | Ebene durch S normal auf u | OrthogonalPlane[S, u] |
| 20 | Ebene b2 | Ebene durch B, zAchse | Ebene[B, zAchse] |
| 21 | Gerade d | Schnittgerade von b2, i | SchneideBahnkurven[b2, i] |
| 22 | Ebene g2 | b2 gedreht um Winkel $(-\alpha) / 2$ um zAchse | Drehe[b2, $(-\alpha) / 2$, zAchse] |
| 23 | Gerade j | Schnittgerade von g2, i | SchneideBahnkurven[g2, i] |
| 24 | Winkel $\delta$ | Winkel zwischen d, j | Winkel[d, j] |
| 25 | Gerade d2 | Schnittgerade von a, g2 | SchneideBahnkurven[a, g2] |
| 26 | Punkt G' | Schnittpunkt von d2, i | Schneide[d2, i] |
| 27 | Vektor f | Vektor[A, G'] | Vektor[A, G'] |
| 28 | Ebene c1 | Ebene durch C, zAchse | Ebene[C, zAchse] |
| 29 | Gerade k | Schnittgerade von c1, i | SchneideBahnkurven[c1, i] |
| 30 | Ebene f1 | c1 gedreht um Winkel $\alpha / 2$ um zAchse | Drehe[c1, $\alpha / 2$, zAchse] |
| 31 | Gerade l | Schnittgerade von f1, i | SchneideBahnkurven[f1, i] |
| 32 | Gerade d1 | Schnittgerade von a, f1 | SchneideBahnkurven[a, f1] |
| 33 | Punkt F | Schnittpunkt von d1,i | Schneide[d1, i] |
| 34 | Winkel $\varepsilon$ | Winkel zwischen k, l | Winkel[k, l] |
| 35 | Vektor w | Vektor[A, F] | Vektor[A, F] |
| 36 | Punkt F, | F gedreht um Winkel $(-\alpha) / 2$ um zAchse | Drehe[F, $(-\alpha) / 2$, zAchse] |
| 37 | Punkt G | G' gedreht um Winkel $\alpha$ um zAchse | Drehe[G', $\alpha$, zAchse] |
| 38 | Vektor e | Vektor[A, G] | Vektor[A, G] |
| 39 | Punkt G, | G' gedreht um Winkel $\alpha / 2$ um zAchse | Drehe[G', $\alpha / 2$, zAchse] |
| 40 | Bogen d, | Umkreisbogen[G, $G_1$, G'] | Umkreisbogen[G, $G_1$, G'] |
| 41 | Winkel $\zeta$ | Winkel zwischen f, e | Winkel[f, e] |
| 42 | Punkt F' | F gedreht um Winkel $-\alpha$ um zAchse | Drehe[F, $-\alpha$, zAchse] |
| 43 | Vektor n, | Vektor[A, F'] | Vektor[A, F'] |
| 44 | Bogen $e_1$ | Umkreisbogen[F, $F_1$, F'] | Umkreisbogen[F, $F_1$, F'] |
| 45 | Winkel $\eta$ | Winkel zwischen $n_1$, w | Winkel[$n_1$, w, xyEbene] |
| 46 | Gerade $Iso_2$ | Gerade durch G, F | Gerade[G, F] |

(fortgesetzt)

| Nr. | Name | Definition | Befehl |
|---|---|---|---|
| 47 | Gerade Iso$_1$ | Gerade durch G', F' | Gerade[G', F'] |
| 48 | Winkel θ | Winkel zwischen Iso$_2$, Iso$_1$ | Winkel[Iso$_2$, Iso$_1$] |
| 49 | Vektor c | Vektor[G', C] | Vektor[G', C] |
| 50 | Vektor b | Vektor[G, B] | Vektor[G, B] |
| 51 | Vektor r | Vektor[B, F] | Vektor[B, F] |
| 52 | Vektor s | Vektor[C, F'] | Vektor[C, F'] |

Die Fig. 17 bis 21 zeigen Verfahren zur Bestimmung der Isogonen für den Fall der "Nicht-Orthogonalität", wo die Verbindungslinie der Bahnpunkte zur Drehebene nicht senkrecht zueinander steht.

In Fig. 19 sind für eine beispielhafte Ausgangssituation ein Drehwinkel alpha (=40°), die Drehebene (xy-Ebene), die Drehachse (z-Achse), der Drehpunkt (A) und die Bahnpunkte zum Start und Ende der Bewegung (hier als B und C bezeichnet) dargestellt.

Zunächst erfolgt Schritt 1: Konstruktion der Symmetrieebene a zwischen B und C.

Fig. 19 zeigt den Schritt 2: Konstruktion des ersten Isogonenpunkt (G') auf erster Isogonen (Iso1):

- b2: Ebene (A,B,zAchse) gedreht um -alpha/2
- d2: Schnittlinie von a und b2
- G': Schnittpunkt von d2 und xy-Ebene

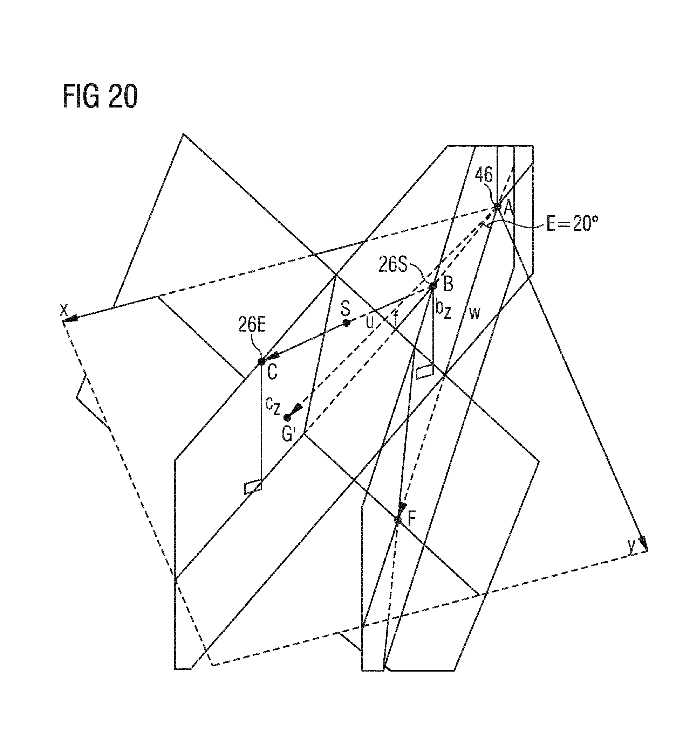

Fig. 20 zeigt den Schritt 3: Konstruktion des ersten Isogonenpunkt (F) auf zweiter Isogonen (Iso2)

- f1: Ebene (A,C ,zAchse) gedreht um alpha/2
- d1: Schnittlinie von a und f1
- F: Schnittpunkt von d1 und xy-Ebene

Es folgt Schritt 4: Konstruktion des zweiten Isogonenpunkts (G) auf erster Isogonen (Iso1):

- G: G' gedreht um Winkel alpha

Dann folgt Schritt 5: Konstruktion des zweiten Isogonenpunkts (F') auf zweiter Isogonen (Iso2)

- F': F gedreht um Winkel -alpha

Dann folgt Schritt 6: Isogonendarstellung

- Isol: Gerade durch Punkte F' und G'
- Iso2: Gerade durch Punkte F und G

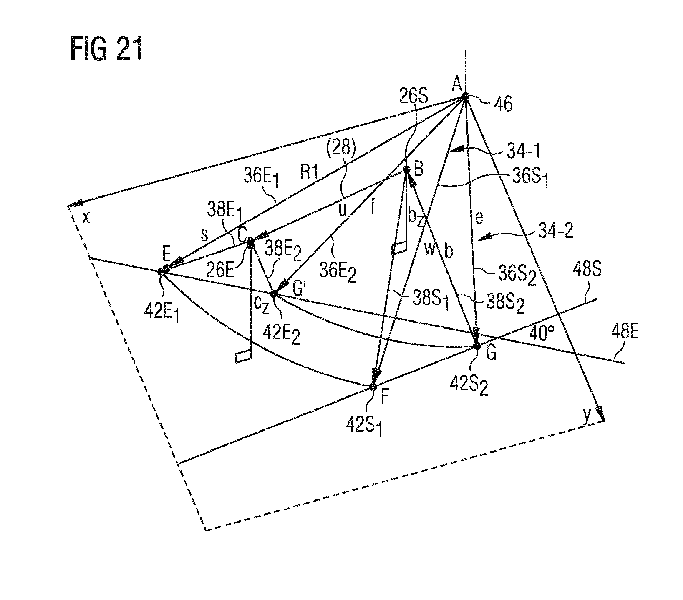

In Fig. 21 sind diese Geraden durch die Punkte F' und G sowie F und G' dargestellt. Damit sind die beiden Linien 48S und 48E für den üblichen 3D-Fall aufgefunden, und es kann ein möglicher Gelenkpunkt durch Auswahl auf einer dieser Linien ausgewählt werden. Mögliche Auswahlen werden im Folgenden anhand der Fig. 21 erläutert.

Fig. 21 zeigt den Schritt 7: Auswahl der Kinematiken

- Winkel alpha zwischen Haupthebel e und f bzw. zwischen w und n1 und zwischen den Isogonen
- System 34-1: gleiche Längen der Haupthebel 36S1 und 36E1 und gleiche Länge der Verbindungsstreben 38S1 und 38E1
- System 34-2: gleiche Längen der Haupthebel 36S2 und 36E2 und gleiche Länge der Verbindungsstreben 38S2 und 38E1.

Im Folgenden werden noch weitere Kriterien für den Schritt b) "Auswahl der geeigneten Gelenkpunkte" erläutert. Hierzu gibt es einen Ansatz, wonach ein dritter Punkt N auf der Verbindungslinie zwischen den Kraftpunkten angenommen wird und hierzu ein Winkel angenommen wird. Beispielsweise kann der Winkel angenommen werden durch ein Verhältnis der jeweiligen Strecken. Liegt N beispielsweise auf 70% der Gesamtstrecke, kann ein Drehwinkel von 70% des Maximalwinkels angenommen werden. Anschließend wird das Isogonen-Problem mit dieser Konstellation gelöst. Ein geeigneter Gelenkpunkt wäre z.B. ein Schnittpunkt zwischen den Isogonen.

Dies ist nur ein Beispiel; beispielsweise könnte vorgesehen sein, dass nicht nur die beiden Kraftangriffspunkte 26S und 26E sondern ein dritter Angriffspunkt angefahren werden soll; dann könnte man auf diese Art und Weise das Problem lösen, siehe Fig. 4.

Ein weiterer Fall der Auswahl ist in Fig. 14 wiedergegeben. Hier gibt es die zwei Beispiele einer Zugstrebe und einer Schubstrebe. Bei der Auswahl der Gelenkpunkte 42 könnte berücksichtigt werden, dass ein Übergangsbereich 48Z zwischen Ziehen und Schieben ausgeblendet wird.

Ein solcher Übergangsfall könnte bei Sonderlösungen möglich sein, beispielsweise zum Feststellen der gesamten Kinematik durch Umklappen; bei dem Anwendungsfall der Droop-Nose ist dies nicht vorgesehen.

Die Fig. 4 zeigt Beispiele, bei denen man relativ viele Zwischenpunkte wählt und die Lösung hierzu ermittelt. Dadurch erhält man beispielsweise einen Bereich möglichst vieler Schnittpunkte der Isogonen. Dieser Bereich könnte gut für die Auswahl des Gelenkpunktes ausgewählt werden.

Die Fig. 9 und 10 zeigen, dass sich Drehwinkel und Bewegungsrichtung nicht in die gleiche Richtung bewegen müssen; es kann auch eine Verdrehung in die eine Richtung und eine Verschiebung in die andere Richtung erfolgen, siehe Fig. 9. Fig. 10 zeigt eine zweite Darstellung, wo der Haupthebel 36 nach links oben geführt ist und die Verbindungsstrebe 38 um einiges länger als der Haupthebel ist. Es gibt auch die Grenzfälle der gestreckten Gestänge. Diese Position wäre jeweils eher nachteilig, da keine Kraft ausgeübt werden kann.

Die Fig. 11 zeigt, dass auch Drehwinkel größer 180° durchaus vorhanden sein können.

Es ist auch eine Lösung denkbar (nicht dargestellt), bei der in der Ausgangsposition die Verbindungsstrebe 38 mit dem Haupthebel 36 fluchtend gegeben ist und auch die Bewegungsbahn 28 fluchtend ist. Dies stellt in der Kinematik des Kurbeltriebs das klassische Schubstangenproblem dar.

Die Fig. 13 zeigt die Anwendung der Isogonen-Technik auf das eingangs genannte Problem. Hier sind die Isogonen $48b_1$ bis $48b_4$ für die unteren Bahnkurven (z.B. die Bahnkurven 28c und 28d in Fig. 1) gegeben. Weiter sind Beispiele für die oberen Bahnkurven 28a oder 28b in Fig. 1 wiedergegeben. Es sind einige Punkte wiedergegeben, die auf den Bahnkurven liegen sollen. Es zeigt sich, dass dann, wenn möglichst ähnliche Isogonen erzeugt werden, ein guter Punkt für die Drehachse gewählt worden ist. Die einzelnen Bahnkurven sind annähernd auf Kreisbahnen zu Rotationsmittelpunkten 50a, 50b.

Mögliche Anwendungsfälle von derartig zu konstruierenden Hebelkinematiken 18, 34 sind die Verbiegung der Haut an Vorderkanten von Flügeln gemäß Fig. 1. Für weitere Einzelheiten hierzu wird auf die nicht vorveröffentlichte europäische Patentanmeldung 13 196 990.9-1754 verwiesen. Weitere mögliche Anwendungsfälle sind das Antreiben von gekoppelten Systemen durch eine gemeinsame drehbare Antriebsstange, insbesondere in Form einer Umwandlung einer Linearbewegung in eine Drehbewegung und umgekehrt - angedeutet durch den Hebelantrieb 19. Für weitere Einzelheiten hierzu wird auf die nicht vorveröffentlichte europäische Patentanmeldung 13196994.1 verwiesen, worin ein Hebelantrieb 19 zum Umwandeln einer Linearbewegung in eine Drehbewegung, beispielsweise zum Antreiben eines Haupthebels einer zu verformenden Struktur nach der 13 196 990.9 beschrieben und gezeigt ist.

Anwendungsfälle sind beispielsweise das Ansteuern von Steuerflächen an Flugzeugen. Auch eine Ansteuerung von anderen fluiddynamisch wirksamen Flächen ist möglich. Beispielsweise ist eine Ansteuerung einer Flügelfläche zur Beeinflussung eines Übergangs von laminarer in turbulente Strömung mittels einer entsprechenden Hebelkinematik möglich. Die Hebelkinematik 18, 34 ist konstruierbar und verwendbar für beliebige Ansteuerungen von Klappen an Flugzeugen und Fluggeräten (Klappenelementen) oder auch für Scharniersysteme für Türen (beispielsweise von Fluggeräten) oder auch eventuell für Fahrwerk-Kinematiken von Fahrzeugen und Luftfahrzeugen.

Weitere Anwendungsgebiete sind Fahrzeuge, beispielsweise aerodynamisch wirksame Flächen von Kraftfahrzeugen, Schiffen, U-Booten, Windkraftanlagen, usw.

Eine Struktur der in Fig. 1 dargestellten Art kann z.B. anstelle an einem Tragflügel eines Flugzeuges in einem Rotorblatt eines Windrades eingesetzt werden. Durch eine Veränderung der flexiblen Hautstruktur an einer Vorderkante und/oder einer Hinterkante lässt sich die Form des Windrad-Rotorflügels sehr schnell einer Veränderung des Windes anpassen. Die Kanten eines Windradflügels können schnell verändert werden, um den Windradflügel den jeweiligen Strömungsverhältnissen anzupassen. Hierzu kann eine Hebelkinematik entsprechend dem oben erläuterten Verfahren entworfen werden.

Der Antrieb der Kantenveränderung kann analog zu dem Antrieb erfolgen, wie er beispielsweise in den europäischen Patentanmeldungen 13 196 990.9 und 13196994.1 beschrieben und gezeigt ist. Insbesondere der in der 13196994.1 gezeigte Linearantrieb ist für Windradflügel sehr interessant, da sich so einfach ein Antrieb der Kantenanpassung von der Nabe aus realisieren lässt.

**Bezugszeichenliste:**

| | |
|---|---|
| 10 | adaptive Struktur |
| 12 | Strukturbauteil |
| 14 | Strömungskörper |
| 15 | Flügel |
| 16 | Lasteinleiteinrichtung |
| 18 | Gesamt-Hebelkinematik |
| 19 | Hebelantrieb |
| 20 | flexible Haut |
| 22 | Cruise-Stellung |
| 24 | High-Lift-Stellung |
| 25 | Omega-Stringer |
| 26 | Kraftangriffspunkt |
| 26a | erster Kraftangriffspunkt |
| 26b | zweiter Kraftangriffspunkt |
| 26c | dritter Kraftangriffspunkt |
| 26d | vierter Kraftangriffspunkt |
| C, B, 26S | Lage Kraftangriffspunkt Start |
| C', C, 26E | Lage Kraftangriffspunkt Ende |
| 28 | Bahnkurve |
| 28a | Bahnkurve des ersten Kraftangriffspunkts |
| 28b | Bahnkurve des zweiten Kraftangriffspunkts |
| 28c | Bahnkurve des dritten Kraftangriffspunkts |
| 28d | Bahnkurve des vierten Kraftangriffspunkts |
| 30 | Aktuatorik |
| 32 | Antrieb |
| 34 | Hebelkinematik |
| 34a | erste Teilkinematik (für ersten Kraftangriffspunkt) |
| 34b | zweite Teilkinematik (für zweiten Kraftgriffspunkt) |
| 34c | dritte Teilkinematik (für dritten Kraftangriffspunkt) |
| 34d | vierte Teilkinematik (für vierten Kraftangriffspunkt) |
| 36 | Haupthebel |
| 36S | Haupthebel (Start) |
| 36E | Haupthebel (Ende) |
| 38 | Verbindungsstrebe |
| 38a | erste Verbindungsstrebe (zum ersten Kraftangriffspunkt) |
| 38b | zweite Verbindungsstrebe (zum zweiten Kraftangriffspunkt) |
| 38c | dritte Verbindungsstrebe (zum dritten Kraftangriffspunkt) |
| 38d | vierte Verbindungsstrebe (zum vierten Kraftangriffspunkt) |
| 40 | Einbauraum |
| 42 | Gelenkpunkt |
| 42a | erster Gelenkpunkt |
| 42b | zweiter bis vierter Gelenkpunkt |
| 44 | Drehachse (Hauptachse) |
| A, 46 | Drehpunkt |
| 48 | Linie aller zulässigen Gelenkpunkte (Isogone) |
| 48S | Linie aller zulässigen Gelenkpunkt (Isogone) beim Start der Bahnkurve |
| 48E | Linie aller zulässigen Gelenkpunkt (Isogone) beim Ende der Bahnkurve |
| α | Drehwinkel |
| LH | Länge des Haupthebels |
| LV | Länge der Verbindungsstrebe |
| S | Start |
| E | Ende |
| w, u | Vektor vom Kraftangriffspunkt beim Start zum Kraftangriffpunkt beim Ende |

**Patentansprüche**

1. Konstruktionsverfahren zum Konstruieren einer Hebelkinematik (34) mit einem Haupthebel (36) und wenigstens einer Verbindungsstrebe (38), wobei der Haupthebel (36) um eine Haupthebelachse um einen vorgegebenen Winkel ($\alpha$) drehbar ist und wobei die Verbindungsstrebe (38) einen Kraftangriffspunkt (26) mit einem Gelenkpunkt (42) an dem Haupthebel (36) verbindet, und wobei bei Beginn des Drehwinkels ($\alpha$) eine erste Lage (26S) des Kraftangriffspunkts (26) vorgegeben ist und am Ende des Drehwinkels ($\alpha$) eine zweite Lage (26E) des Kraftangriffspunkts (26) vorgegeben ist, **gekennzeichnet durch** den Schritt:

   a) Darstellen einer Linie (48, 48S, 48E) der möglichen Gelenkpunkte (42) für den gegebenen Drehwinkel ($\alpha$), die Hauptachse (44) und die erste und zweite Lage des Kraftangriffspunkts (26), als Auswahlhilfe zum Auswählen des Gelenkpunkts.

2. Verfahren nach Anspruch 1, **gekennzeichnet durch** den Schritt:

   b) Auswahl des Gelenkpunkts (42) auf der Linie (48, 48S, 48E).

3. Konstruktionsverfahren nach einem der voranstehenden Ansprüche , **gekennzeichnet durch**
   geometrisches Darstellen des Haupthebels (36) und der Verbindungsstrebe (38) zu Beginn und Ende des Drehwinkels ($\alpha$).

4. Konstruktionsverfahren nach einem der voranstehenden Ansprüche, **dadurch gekennzeichnet, dass** Schritt a) enthält:

   Darstellen der Linie (48S) der möglichen Gelenkpunkte (42) für den Beginn des Drehwinkels ($\alpha$) und Darstellen der Linie (48E) der möglichen Gelenkpunkte (42) für das Ende des Drehwinkels ($\alpha$).

5. Konstruktionsverfahren nach einem der voranstehenden Ansprüche, **dadurch gekennzeichnet, dass** Schritt a) enthält:

   geometrisches Konstruieren der Linie (48, 48S, 48E) in Form einer Geraden aufgrund von

   • Parallelitätsbedingungen,
   • Symmetriebedingungen,
   • Kollinearitätsbedingungen und/oder
   • Rechtwinkligkeitsbedingungen.

6. Konstruktionsverfahren nach Anspruch 2 oder nach einem der Ansprüche 3 bis 5, soweit auf Anspruch 2 zurückbezogen, **dadurch gekennzeichnet, dass** Schritt b) enthält:

   Auswahl des Gelenkpunktes (42) aufgrund von Randbedingungen und/oder Platzverhältnissen für die Hebelkinematik (34).

7. Konstruktionsverfahren nach Anspruch 4 und nach Anspruch 6, **dadurch gekennzeichnet, dass** die Auswahl des Gelenkpunkts (42) anhand von Randbedingungen an beiden Endpunkten des Drehwinkels ($\alpha$) erfolgt.

8. Hebelmechanikkonstruktionsverfahren zur Konstruktion einer Hebelmechanikanordnung mit gekoppelten Hebelkinematiken (34), von denen jede Hebelkinematik (34) umfasst: einen Haupthebel (36) und wenigstens eine Verbindungsstrebe (38) derart, dass der Haupthebel (36) um eine Haupthebelachse um einen vorgegebenen Winkel ($\alpha$) drehbar ist und dass die Verbindungsstrebe (38) einen Kraftangriffspunkt (26) mit einem Gelenkpunkt (42) an dem Haupthebel (36) verbindet, und dass bei Beginn des Drehwinkels ($\alpha$) eine erste Lage des Kraftangriffspunkts (26) vorgegeben ist und am Ende des Drehwinkels ($\alpha$) eine zweite Lage des Kraftangriffspunkts (26) vorgegeben ist, umfassend:

Auswählen derjenigen der Hebelkinematiken (34), die die meisten Randbedingungen zu erfüllen hat, als überrangige Master-Kinematik,

Durchführen des Konstruktionsverfahrens nach einem der voranstehenden Ansprüche für die Master-Kinematik und

nachfolgendes Durchführen des Konstruktionsverfahrens für eine weitere gekoppelte Hebelkinematik (34) unter Berücksichtigung der Konstruktion der Masterkinematik als Randbedingung.

9. Verwenden des Konstruktionsverfahrens nach einem der Ansprüche 1 bis 7 und/oder des Hebelmechanikkonstruktionsverfahren nach Anspruch 8:

a) zur Konstruktion einer Antriebsmechanik zur Strukturverformung flexibler Hautstrukturen, oder

b) zur Konstruktion einer Antriebsmechanik für eine Hochauftriebsanordnung an einer Flügelvorderkante eines Luftfahrzeugs, oder

c) zur Konstruktion einer Ansteuerung von Steuerflächen an Flugzeugen, Hubschraubern oder sonstigen Luftfahrzeugen, oder

d) zur Konstruktion einer Ansteuerung von fluiddynamisch wirksamen Flächen an fluiddynamischen Körpern, oder

e) zur Konstruktion einer Ansteuerung von Klappen an Fahrzeugen, Luftfahrzeugen und Fluggeräten, oder

f) zur Konstruktion von Fahrwerkkinematiken von Fahrzeugen und Luftfahrzeugen, oder

g) zur Konstruktion von Scharniersystemen oder Bewegungskinematiken von Türen, beispielsweise von Fahrzeugen und Luftfahrzeugen oder

i) zur Konstruktion einer Ansteuerung zur Veränderung der Profilform eines Windradflügels.

10. Herstellverfahren zum Herstellen einer Hebelkinematik (34), mit einem Haupthebel (36) und wenigstens einer Verbindungsstrebe (38), wobei der Haupthebel (36) um eine Haupthebelachse um einen vorgegebenen Winkel ($\alpha$) drehbar ist und wobei die Verbindungsstrebe (38) einen Kraftangriffspunkt (26) mit einem Gelenkpunkt (42) an dem Haupthebel (36) verbindet, und wobei bei Beginn des Drehwinkels ($\alpha$) eine erste Lage des Kraftangriffspunkts (26) vorgegeben ist und am Ende des Drehwinkels ($\alpha$) eine zweite Lage des Kraftangriffspunkts (26) vorgegeben ist, mit den Schritten:

Durchführen eines Konstruktionsverfahrens nach einem der Ansprüche 1 bis 8 und Herstellen des Haupthebels (36) und der Verbindungsstrebe (38) und aneinander Anlenken derselben an dem durch das Konstruktionsverfahren ermittelten Gelenkpunkt (42).

11. Computerprogrammprodukt, **dadurch gekennzeichnet,**
**dass** es ein Computerprogramm mit Computerprogrammcodemitteln umfasst, das dazu ausgebildet ist, einen Computer oder Prozessor zum Ausführen der Schritte eines Verfahrens nach einem der Ansprüche 1 bis 8 zu veranlassen.

Fig. 1

LV (LVa-LVd)

22

26
26S

$t_{START}$

28

26
26E

24

$t_{ENDE}$

38
(38a-38d)

38

42

42

Fig. 2

36

36

α

34

LH

44

46

Fig. 3

**Fig. 4**

EP 3 020 629 A1

## FIG 5

## FIG 6

FIG 7

FIG 8

FIG 9

$G_E$

48

48S

48E

$G_E$

42E

$G_S$

36E

α

42S

38S

46, 44

36S

$G_S$

38E

26S

w

28

26E

FIG 10

$G_E$

48S

$G_E$

α

42S

42E

36S

38S

36E

48E

$G_S$

46, 44

26S

38E

w

28

26E

FIG 11

FIG 12

FIG 13

EP 3 020 629 A1

FIG 14

FIG 15

FIG 16

FIG 17

FIG 18

EP 3 020 629 A1

## FIG 19

FIG 20

FIG 21

**Europäisches Patentamt**
**European Patent Office**
**Office européen des brevets**

## EUROPÄISCHER RECHERCHENBERICHT

Nummer der Anmeldung

EP 14 19 3280

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 0 407 238 A2 (SCHLUMBERGER TECHNOLOGIES INC [US]) 9. Januar 1991 (1991-01-09) * das ganze Dokument * ----- | 1-11 | INV. B64C3/48 ADD. F16H57/00 F16H21/10 G06F17/50 B64C3/44 |
| A | EP 0 103 038 A1 (BOEING CO [US]) 21. März 1984 (1984-03-21) * das ganze Dokument * ----- | 1 | |

RECHERCHIERTE SACHGEBIETE (IPC)

B64C
F16H
G06F

Der vorliegende Recherchenbericht wurde für alle Patentansprüche erstellt

| Recherchenort | Abschlußdatum der Recherche | Prüfer |
|---|---|---|
| München | 9. Juli 2015 | Masset, Candie |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 14 19 3280

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-07-2015

| Im Recherchenbericht angeführtes Patentdokument | Datum der Veröffentlichung | Mitglied(er) der Patentfamilie | Datum der Veröffentlichung |
|---|---|---|---|
| EP 0407238 A2 | 09-01-1991 | EP 0407238 A2<br>JP 2905263 B2<br>JP H03129476 A | 09-01-1991<br>14-06-1999<br>03-06-1991 |
| EP 0103038 A1 | 21-03-1984 | KEINE | |

EPO FORM P0461

Für nähere Einzelheiten zu diesem Anhang : siehe Amtsblatt des Europäischen Patentamts, Nr.12/82

**EP 3 020 629 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0130983 B1
- US 4427168 A
- EP 1319699091754 A
- DE 2907912 A1
- EP 13196990 A
- EP 13196994 A